# EUROPEAN PATENT APPLICATION

(11) **EP 4 800 480 A2**
(43) Date of publication of application: **02.09.2026**
(21) Application number: 26184407.0
(22) Date of filing: 21.02.2022
(51) Int. Cl.: G03F 7/16

(54) **SUBSTRATE WITH THIN FILM, AND SEMICONDUCTOR SUBSTRATE**

(30) Priority: 22.02.2021 JP 2021026635
(62) Document number(s) of the earlier application(s) in accordance with Art. 76 EPC: 22756316.0 / 4 296 272
(71) Applicant: Nissan Chemical Corporation, Tokyo 103-6119 (JP)
(72) Inventor: SHIBAYAMA, Wataru, Toyama-shi, Toyama, 939-2792 (JP); TAKEDA, Satoshi, Toyama-shi, Toyama, 939-2792 (JP); SHIGAKI, Shuhei, Toyama-shi, Toyama, 939-2792 (JP); ISHIBASHI, Ken, Toyama-shi, Toyama, 939-2792 (JP); KATO, Kodai, Toyama-shi, Toyama, 939-2792 (JP); NAKAJIMA, Makoto, Toyama-shi, Toyama, 939-2792 (JP); SAKAMOTO, Rikimaru, Toyama-shi, Toyama, 939-2792 (JP)
(74) Representative: Hoffmann Eitle

(57) **Abstract**

A substrate with a thin film, including
the thin film including a Si-R¹ group of a compound represented by Formula (1), and
the substrate including the thin film including the Si-R¹ group, the thin film being disposed on a surface of the substrate,

Si(R¹)(R²)ₙ(R³)₃₋ₙ ··· Formula (1)

where in Formula (1), R¹ represents a monovalent organic group that bonds to Si; R² represents a monovalent organic group that bonds to Si; R³ represents an alkoxy group, an acyloxy group, or a halogen atom that bonds to Si; n represents an integer from 0 to 2; when n is 2, R² may be the same or different; when n is 0 or 1, R³ may be the same or different; and when n is 1, R¹ and R² may bond together to form a ring structure.

## Description

### Technical Field

The present invention relates to a substrate with a thin film, a semiconductor substrate, a method of manufacturing a substrate with a thin film, and a method of manufacturing a semiconductor substrate, as well as a compound used in the foregoing.

### Background Art

There are several known methods for producing a thin film on a substrate in addition to the coating method in which a liquid is applied onto a substrate. One of the widely used techniques is chemical vapor deposition (CVD). In the CVD method, a raw material gas containing a component of a target thin film is supplied onto a substrate, producing a thin film via a chemical reaction at the substrate surface or in a gas phase.

CVD techniques proposed in recent years include atomic layer deposition (ALD) and molecular layer deposition.

There have been proposals of forming a gallium nitride thin film (for example, Patent Document 1) or forming an organic polymer (for example, Patent Document 2) using these techniques.

### Citation List

### Patent Literature

Patent Document 1: WO 2020/170853
Patent Document 2: JP 2014-129606 A

### Summary of Invention

### Technical Problem

An object of the present invention is to provide a substrate with a thin film and a semiconductor substrate, both having a novel thin film formed on the substrate, and to provide a method of manufacturing a substrate with a thin film and a method of manufacturing a semiconductor substrate, both capable of forming a novel thin film on the substrate, as well as to provide a compound used in the foregoing.

### Solution to Problem

As a result of intensive studies in order to solve the above problems, the present inventors found that the above problems can be solved, and completed the present invention having the following gist.

That is, the present invention includes the following.
[1] A substrate with a thin film, including
   the thin film having a Si-R¹ group of a compound represented by Formula (1) below, and
   the substrate including the thin film having the Si-R¹ group, the thin film being disposed on a surface of the substrate.

      Si(R¹)(R²)ₙ(R³)₃₋ₙ ··· Formula(1)
   where in Formula (1), R¹ represents a monovalent organic group that bonds to Si; R² represents a monovalent organic group that bonds to Si; R³ represents an alkoxy group, an acyloxy group, or a halogen atom that bonds to Si; n represents an integer from 0 to 2; when n is 2, R² may be the same or different; when n is 0 or 1, R³ may be the same or different; and when n is 1, R¹ and R² may bond together to form a ring structure.
[2] The substrate with a thin film according to [1], wherein the substrate with a thin film is formed by bringing the compound represented by Formula (1) into contact with the surface of the substrate and further chemically reacting the compound.
[3] The substrate with a thin film according to [1] or [2], wherein the monovalent organic group in R¹ is a monovalent organic group having from 1 to 20 carbons and an oxygen atom.
[4] The substrate with a thin film according to any one of [1] to [3], wherein in Formula (1), R¹ represents a monovalent group represented by Formula (2) below, and R² represents a monovalent group represented by Formula (2), or an alkyl group, an aryl group, an aralkyl group, a halogenated alkyl group, a halogenated aryl group, a halogenated aralkyl group, an alkenyl group, an organic group having an epoxy group, an organic group having an acryloyl group, an organic group having a methacryloyl group, an organic group having a mercapto group, an organic group having an amino group, an organic group having a cyano group, or a combination of two or more types of the foregoing, 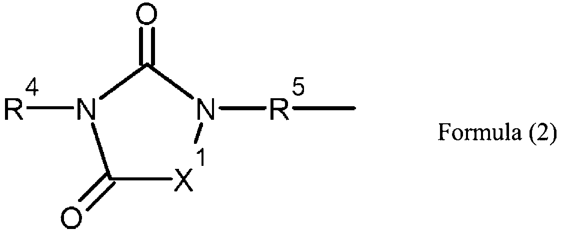
   where in Formula (2), R⁴ represents a hydrogen atom, an alkyl group having from 1 to 10 carbons, an alkenyl group, an epoxy group, a sulfonyl group, or a monovalent organic group containing two or more types of the foregoing; R⁵ represents an alkylene group having from 1 to 10 carbons, a hydroxyalkylene group, a sulfide bond, an ether bond, an ester bond, or a combination of two or more types of the foregoing; and X¹ represents a divalent group represented by Formula (3) below, a divalent group represented by Formula (4), or a divalent group represented by Formula (5), 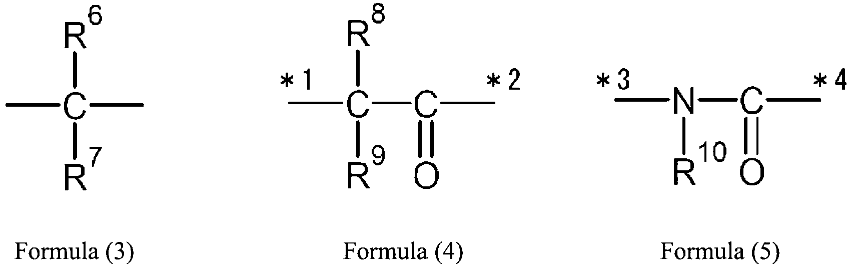
   where in Formula (3), Formula (4), and Formula (5), R⁶ to R¹⁰ each independently represent a hydrogen atom, an alkyl group having from 1 to 10 carbons, an alkenyl group, an epoxy group, a sulfonyl group, or a monovalent organic group containing two or more types of the foregoing; *1 and *3 are bonded to a carbon atom of a carbonyl group in Formula (2); and *2 and *4 are bonded to a nitrogen atom in Formula (2).
[5] A semiconductor substrate including
   the substrate with a thin film described in any one of [1] to [4], and
   a resist film disposed above the thin film.
[6] A method of manufacturing a substrate with a thin film, the method including
   bringing a gaseous compound represented by Formula (1) into contact with a surface of a substrate, and further chemically reacting the compound to form a thin film having a Si-R1 group of the compound on the surface of the substrate,

      Si(R¹)(R²)ₙ(R³)₃₋ₙ ··· Formula (1)
   where in Formula (1), R¹ represents a monovalent organic group that bonds to Si; R² represents a monovalent organic group that bonds to Si; R³ represents an alkoxy group, an acyloxy group, or a halogen atom that bonds to Si; n represents an integer from 0 to 2; when n is 2, R² may be the same or different; when n is 0 or 1, R³ may be the same or different; and when n is 1, R¹ and R² may bond together to form a ring structure.
[7] The method of manufacturing a substrate with a thin film according to [6], wherein
   the formation of the thin film on the surface of the substrate is performed in a film formation chamber, and
   the method further includes retrieving, from the film formation chamber, the substrate including the thin film having the Si-R¹ group, the thin film being formed on the surface of the substrate.
[8] The method of manufacturing a substrate with a thin film according to [6] or [7], wherein the monovalent organic group in R¹ is a monovalent organic group having from 1 to 20 carbons and an oxygen atom.
[9] The method of manufacturing a substrate with a thin film according to any one of [6] to [8], wherein in Formula (1), R¹ represents a monovalent group represented by Formula (2) below, and R² represents a monovalent group represented by Formula (2), or an alkyl group, an aryl group, an aralkyl group, a halogenated alkyl group, a halogenated aryl group, a halogenated aralkyl group, an alkenyl group, an organic group having an epoxy group, an organic group having an acryloyl group, an organic group having a methacryloyl group, an organic group having a mercapto group, an organic group having an amino group, an organic group having a cyano group, or a combination of two or more types of the foregoing, 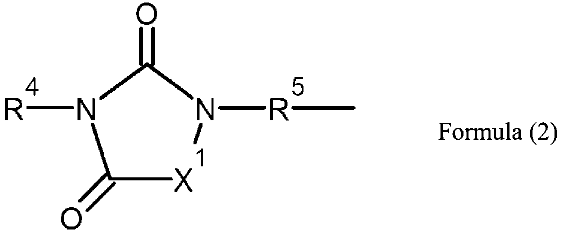
   where in Formula (2), R⁴ represents a hydrogen atom, an alkyl group having from 1 to 10 carbons, an alkenyl group, an epoxy group, a sulfonyl group, or a monovalent organic group containing two or more types of the foregoing; R⁵ represents an alkylene group having from 1 to 10 carbons, a hydroxyalkylene group, a sulfide bond, an ether bond, an ester bond, or a combination of two or more types of the foregoing; and X¹ represents a divalent group represented by Formula (3) below, a divalent group represented by Formula (4), or a divalent group represented by Formula (5), 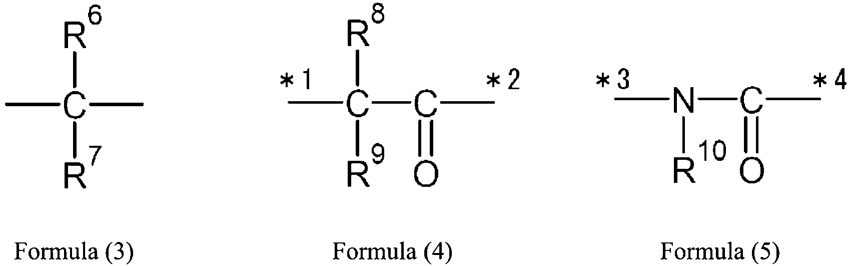
   where in Formula (3), Formula (4), and Formula (5), R⁶ to R¹⁰ each independently represent a hydrogen atom, an alkyl group having from 1 to 10 carbons, an alkenyl group, an epoxy group, a sulfonyl group, or a monovalent organic group containing two or more types of the foregoing; *1 and *3 are bonded to a carbon atom of a carbonyl group in Formula (2); and *2 and *4 are bonded to a nitrogen atom in Formula (2).
[10] The method of manufacturing a substrate with a thin film according to any one of [6] to [9], the method including gasifying the compound represented by Formula (1).
[11] A method of manufacturing a semiconductor substrate, the method including:
   manufacturing a substrate with a thin film by using the method of manufacturing a substrate with a thin film described in any one of [6] to [10]; and
   forming a resist film above the thin film.
[12] A compound represented by Formula (1) for use in any one of:
   manufacturing of the substrate with a thin film described in any one of [1] to [4];
   manufacturing of the semiconductor substrate described in [5];
   the method of manufacturing a substrate with a thin film described in any one of [6] to [10]; and
   the method of manufacturing a semiconductor substrate described in [11].

### Advantageous Effects of Invention

The present invention can provide a substrate with a thin film and a semiconductor substrate, both having a novel thin film formed on the substrate, and can provide a method of manufacturing a substrate with a thin film and a method of manufacturing a semiconductor substrate, both capable of forming a novel thin film on the substrate, as well as can provide a compound used in the foregoing.

### Brief Description of Drawings

FIG. 1 is a schematic cross-sectional view of an example of a substrate with a thin film.
FIG. 2 is a schematic cross-sectional view of another example of the substrate with a thin film.
FIG. 3 is a schematic cross-sectional view of an example of a manufacturing device for the substrate with a thin film.

### Description of Embodiments

### Method of Manufacturing Substrate With Thin Film

A method of manufacturing a substrate with a thin film according to an embodiment of the present invention is a method of manufacturing a substrate with a thin film having a Si-R¹ group of a compound represented by Formula (1) below.

The method of manufacturing a substrate with a thin film includes at least forming a thin film, and further includes gasifying the compound and retrieving the substrate as necessary.

### Gasification of Compound

This step is a step of gasifying the compound represented by Formula (1) below.

The method of gasifying the compound is not particularly limited, and examples thereof include a method of gasifying (vaporizing) the compound represented by Formula (1) by heating a raw material container containing the compound represented by Formula (1), by depressurizing the interior of the raw material container containing the compound represented by Formula (1), or by a combination of the foregoing.

Note that, gasifying the compound represented by Formula (1) may be performed in the raw material container as described above, or may be performed using a vaporization chamber instead of the raw material container. Sizes, materials, and structures of the raw material container and the vaporization chamber are not particularly limited and may be appropriately determined in consideration of a heating temperature and a degree of depressurization.

The heating temperature is not particularly limited, and is, for example, from 25 to 200°C.

When gasifying the compound represented by Formula (1), a pressure in the raw material container and a pressure in the vaporization chamber are not particularly limited, and are, for example, from 1 to 10000 Pa.

The compound represented by Formula (1) may be liquid or solid at normal temperature and normal pressure.
Formula (1)

Si(R¹)(R²)ₙ(R³)₃₋ₙ ··· Formula(1)

where in Formula (1), R¹ represents a monovalent organic group that bonds to Si; R² represents a monovalent organic group that bonds to Si; R³ represents an alkoxy group, an acyloxy group, or a halogen atom that bonds to Si; n represents an integer from 0 to 2; when n is 2, R² may be the same or different; when n is 0 or 1, R³ may be the same or different; and when n is 1, R¹ and R² may bond together to form a ring structure.

The monovalent organic groups in R¹ and R² are, for example, organic groups having from 1 to 20 carbons.

The monovalent organic groups in R¹ and R² may have a hetero atom in addition to a carbon atom and a hydrogen atom. Examples of the hetero atom include a nitrogen atom, an oxygen atom, a sulfur atom, and a phosphorus atom.

The monovalent organic groups in R¹ and R² may be bonded to a silicon atom via a Si-C bond.

The monovalent organic groups in R¹ and R² may have, for example, an alkyl group, a carbonyl group, an amide group, an imide group, an amino group, an imino group, or an alkenyl group, or a combination of two or more types of the foregoing.

R¹ and R² are, for example, each independently free of protected functional groups. Examples of the protected functional groups include, for example, a protected amino group.

The compound represented by Formula (1) is, for example, a hydrolyzable organosilane represented by Formula (1) in WO 2011/102470 pamphlet.

R¹ represents, for example, a monovalent group represented by Formula (2) below. 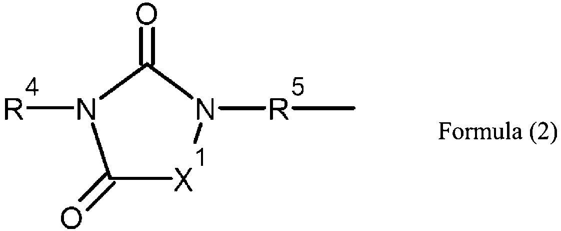
where in Formula (2), R⁴ represents a hydrogen atom, an alkyl group having from 1 to 10 carbons, an alkenyl group, an epoxy group, a sulfonyl group, or a monovalent organic group containing two or more types of the foregoing; R⁵ represents an alkylene group having from 1 to 10 carbons, a hydroxyalkylene group, a sulfide bond, an ether bond, an ester bond, or a combination of two or more types of the foregoing; and X¹ represents a divalent group represented by Formula (3) below, a divalent group represented by Formula (4), or a divalent group represented by Formula (5), 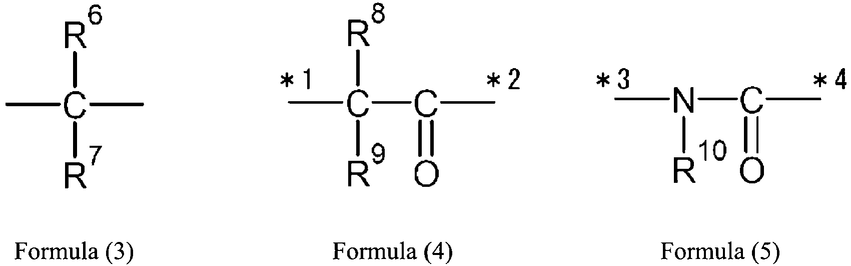
where in Formula (3), Formula (4), and Formula (5), R⁶ to R¹⁰ each independently represent a hydrogen atom, an alkyl group having from 1 to 10 carbons, an alkenyl group, an epoxy group, a sulfonyl group, or a monovalent organic group containing two or more types of the foregoing, *1 and *3 are bonded to a carbon atom of a carbonyl group in Formula (2), *2 and *4 are bonded to a nitrogen atom in Formula (2).

R² preferably represents, for example, a monovalent group represented by Formula (2). Alternatively, R² is, for example, an alkyl group, an aryl group, an aralkyl group, a halogenated alkyl group, a halogenated aryl group, a halogenated aralkyl group, an alkenyl group, an organic group having an epoxy group, an organic group having an acryloyl group, an organic group having a methacryloyl group, an organic group having a mercapto group, an organic group having an amino group, an organic group having a cyano group, or a combination of two or more types of the foregoing.

The alkyl group is, for example, an alkyl group having from 1 to 10 carbons.

The alkyl group may have a linear structure or a branched structure.

Examples of the linear or branched alkyl group having from 1 to 10 carbons include a methyl group, an ethyl group, an n-propyl group, an i-propyl group, an n-butyl group, an i-butyl group, an s-butyl group, a t-butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group.

The alkyl group may also be an alkyl group having a cyclic alkyl group. Examples of the alkyl group having from 1 to 10 carbons and having a cyclic alkyl group include a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

Examples of the alkylene group having from 1 to 10 carbons include alkylene groups derived from the alkyl groups described above.

The aryl group is, for example, an aryl group having from 6 to 20 carbons. Examples of the aryl group having from 6 to 20 carbons include a phenyl group, an o-methylphenyl group, an m-methylphenyl group, a p-methylphenyl group, an o-chlorophenyl group, a m-chlorophenyl group, a p-chlorophenyl group, an o-fluorophenyl group, a p-mercaptophenyl group, an o-methoxyphenyl group, a p-methoxyphenyl group, a p-aminophenyl group, a p-cyanophenyl group, an α-naphthyl group, a β-naphthyl group, an o-biphenylyl group, an m-biphenylyl group, a p-biphenylyl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

The alkenyl group is, for example, an alkenyl group having from 2 to 10 carbons. Examples of the alkenyl group having from 2 to 10 carbons include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, a 2-methyl-1-butenyl group, a 2-methyl-2-butenyl group, a 2-methyl-3-butenyl group, a 3-methyl-1-butenyl group, a 3-methyl-2-butenyl group, a 3-methyl-3-butenyl group, a 1,1-dimethyl-2-propenyl group, a 1-i-propylethenyl group, a 1,2-dimethyl-1-propenyl group, a 1,2-dimethyl-2-propenyl group, a 1-cyclopentenyl group, a 2-cyclopentenyl group, a 3-cyclopentenyl group, a 1-hexenyl group, a 2-hexenyl group, a 3-hexenyl group, a 4-hexenyl group, a 5-hexenyl group, a 1-methyl-1-pentenyl group, a 1-methyl-2-pentenyl group, a 1-methyl-3-pentenyl group, a 1-methyl-4-pentenyl group, a 1-n-butylethenyl group, a 2-methyl-1-pentenyl group, a 2-methyl-2-pentenyl group, a 2-methyl-3-pentenyl group, a 2-methyl-4-pentenyl group, a 2-n-propyl-2-propenyl group, a 3-methyl-1-pentenyl group, a 3-methyl-2-pentenyl group, a 3-methyl-3-pentenyl group, a 3-methyl-4-pentenyl group, a 3-ethyl-3-butenyl group, a 4-methyl-1-pentenyl group, a 4-methyl-2-pentenyl group, a 4-methyl-3-pentenyl group, a 4-methyl-4-pentenyl group, a 1,1-dimethyl-2-butenyl group, a 1,1-dimethyl-3-butenyl group, a 1,2-dimethyl-1-butenyl group, a 1,2-dimethyl-2-butenyl group, a 1,2-dimethyl-3-butenyl group, a 1-methyl-2-ethyl-2-propenyl group, a 1-s-butylethenyl group, a 1,3-dimethyl-1-butenyl group, a 1,3-dimethyl-2-butenyl group, a 1,3-dimethyl-3-butenyl group, a 1-i-butylethenyl group, a 2,2-dimethyl-3-butenyl group, a 2,3-dimethyl-1-butenyl group, a 2,3-dimethyl-2-butenyl group, a 2,3-dimethyl-3-butenyl group, a 2-i-propyl-2-propenyl group, a 3,3-dimethyl-1-butenyl group, a 1-ethyl-1-butenyl group, a 1-ethyl-2-butenyl group, a 1-ethyl-3-butenyl group, a 1-n-propyl-1-propenyl group, a 1-n-propyl-2-propenyl group, a 2-ethyl-1-butenyl group, a 2-ethyl-2-butenyl group, a 2-ethyl-3-butenyl group, a 1,1,2-trimethyl-2-propenyl group, a 1-t-butylethenyl group, a 1-methyl-1-ethyl-2-propenyl group, a 1-ethyl-2-methyl-1-propenyl group, a 1-ethyl-2-methyl-2-propenyl group, a 1-i-propyl-1-propenyl group, a 1-i-propyl-2-propenyl, a 1-methyl-2-cyclopentenyl group, a 1-methyl-3-cyclopentenyl group, a 2-methyl-1-cyclopentenyl group, a 2-methyl-2-cyclopentenyl group, a 2-methyl-3-cyclopentenyl group, a 2-methyl-4-cyclopentenyl group, a 2-methyl-5-cyclopentenyl group, a 2-methylene-cyclopentyl group, a 3-methyl-1-cyclopentenyl group, a 3-methyl-2-cyclopentenyl group, a 3-methyl-3-cyclopentenyl group, a 3-methyl-4-cyclopentenyl group, a 3-methyl-5-cyclopentenyl group, a 3-methylene-cyclopentyl group, a 1-cyclohexenyl group, a 2-cyclohexenyl group, and a 3-cyclohexenyl group.

The aralkyl group is an alkyl group substituted with an aryl group. The aralkyl group is, for example, an alkyl group having from 1 to 10 carbons substituted with a phenyl group. Examples of the aralkyl group include a benzyl group, a phenylethyl group, a phenylpropyl group, and a phenylbutyl group.

Examples also include organic groups in which the hydrogen atoms of these alkyl groups, aryl groups, and aralkyl groups are substituted with halogen atoms such as fluorine, chlorine, bromine, and iodine (halogenated alkyl groups, halogenated aryl groups, and halogenated aralkyl groups). The substitution with a halogen atom may be performed on all hydrogen atoms or may be performed on a part of the hydrogen atoms.

The hydroxyalkylene group is a group in which at least one hydrogen atom of an alkylene group is substituted with a hydroxy group. The hydroxyalkylene group is, for example, a hydroxyalkylene group having from 1 to 10 carbons. Examples of the hydroxyalkylene group include a 1-hydroxyethylene group, a 2-hydroxyethylene group, a 1-hydroxypropylene group, a 2-hydroxypropylene group, a 3-hydroxypropylene group, a hydroxybutylene group, a hydroxypentylene group, and a hydroxyhexylene group.

Examples of the organic group having an epoxy group include a glycidoxymethyl group, a glycidoxyethyl group, a glycidoxypropyl group, a glycidoxybutyl group, and an epoxycyclohexyl group.

Examples of the organic group having an acryloyl group include an acryloyloxymethyl group, an acryloyloxyethyl group, and an acryloyloxypropyl group.

Examples of the organic group having a methacryloyl group include a methacryloyloxymethyl group, a methacryloyloxyethyl group, and a methacryloyloxypropyl group.

Examples of the organic group having a mercapto group include a mercaptoethyl group, a mercaptobutyl group, a mercaptohexyl group, and a mercaptooctyl group.

Examples of the organic group having a cyano group include a cyanoethyl group and a cyanopropyl group.

Examples of the organic group having an amino group include an aminomethyl group, an aminoethyl group, and an aminopropyl group.

Examples of the organic group having a sulfonyl group include a methylsulfonyl group, an allylsulfonyl group, and a phenylsulfonyl group.

The alkoxy group in R³ in Formula (1) is, for example, an alkoxy group having from 1 to 20 carbons. Examples of the alkoxy group having from 1 to 20 carbons include an alkoxy group that has from 1 to 20 carbons and that is linear or branched, or has a cyclic alkyl moiety.

Examples of the linear or branched alkoxy group include a methoxy group, an ethoxy group, an n-propoxy group, an i-propoxy group, an n-butoxy group, an i-butoxy group, an s-butoxy group, a t-butoxy group, an n-pentyloxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, an n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2-trimethyl-n-propoxy group, a 1-ethyl-1-methyl-n-propoxy group, and a 1-ethyl-2-methyl-n-propoxy group.

Examples of the alkoxy group that has a cyclic alkyl moiety include a cyclopropoxy group, a cyclobutoxy group, a 1-methyl-cyclopropoxy group, a 2-methyl-cyclopropoxy group, a cyclopentyloxy group, a 1-methyl-cyclobutoxy group, a 2-methyl-cyclobutoxy group, a 3-methyl-cyclobutoxy group, a 1,2-dimethyl-cyclopropoxy group, a 2,3-dimethyl-cyclopropoxy group, a 1-ethyl-cyclopropoxy group, a 2-ethyl-cyclopropoxy group, a cyclohexyloxy group, a 1-methyl-cyclopentyloxy group, a 2-methyl-cyclopentyloxy group, a 3-methyl-cyclopentyloxy group, a 1-ethyl-cyclobutoxy group, a 2-ethyl-cyclobutoxy group, a 3-ethyl-cyclobutoxy group, a 1,2-dimethyl-cyclobutoxy group, a 1,3-dimethyl-cyclobutoxy group, a 2,2-dimethyl-cyclobutoxy group, a 2,3-dimethyl-cyclobutoxy group, a 2,4-dimethyl-cyclobutoxy group, a 3,3-dimethyl-cyclobutoxy group, a 1-n-propyl-cyclopropoxy group, a 2-n-propyl-cyclopropoxy group, a 1-i-propyl-cyclopropoxy group, a 2-i-propyl-cyclopropoxy group, a 1,2,2-trimethyl-cyclopropoxy group, a 1,2,3-trimethyl-cyclopropoxy group, a 2,2,3-trimethyl-cyclopropoxy group, a 1-ethyl-2-methyl-cyclopropoxy group, a 2-ethyl-1-methyl-cyclopropoxy group, a 2-ethyl-2-methyl-cyclopropoxy group, and a 2-ethyl-3-methyl-cyclopropoxy group.

The acyloxy group represented by R³ in Formula (1) is, for example, an acyloxy group having from 2 to 20 carbons. Examples of the acyloxy group having from 2 to 20 carbons include a methylcarbonyloxy group, an ethylcarbonyloxy group, an n-propylcarbonyloxy group, an i-propylcarbonyloxy group, an n-butylcarbonyloxy group, an i-butylcarbonyloxy group, an s-butylcarbonyloxy group, a t-butylcarbonyloxy group, an n-pentylcarbonyloxy group, a 1-methyl-n-butylcarbonyloxy group, a 2-methyl-n-butylcarbonyloxy group, a 3-methyl-n-butylcarbonyloxy group, a 1,1-dimethyl-n-propylcarbonyloxy group, a 1,2-dimethyl-n-propylcarbonyloxy group, a 2,2-dimethyl-n-propylcarbonyloxy group, a 1-ethyl-n-propylcarbonyloxy group, an n-hexylcarbonyloxy group, a 1-methyl-n-pentylcarbonyloxy group, a 2-methyl-n-pentylcarbonyloxy group, a 3-methyl-n-pentylcarbonyloxy group, a 4-methyl-n-pentylcarbonyloxy group, a 1,1-dimethyl-n-butylcarbonyloxy group, a 1,2-dimethyl-n-butylcarbonyloxy group, a 1,3-dimethyl-n-butylcarbonyloxy group, a 2,2-dimethyl-n-butylcarbonyloxy group, a 2,3-dimethyl-n-butylcarbonyloxy group, a 3,3-dimethyl-n-butylcarbonyloxy group, a 1-ethyl-n-butylcarbonyloxy group, a 2-ethyl-n-butylcarbonyloxy group, a 1,1,2-trimethyl-n-propylcarbonyloxy group, a 1,2,2-trimethyl-n-propylcarbonyloxy group, a 1-ethyl-1-methyl-n-propylcarbonyloxy group, a 1-ethyl-2-methyl-n-propylcarbonyloxy group, a phenylcarbonyloxy group, and a tosylcarbonyloxy group.

Examples of the halogen atom in R³ in Formula (1) include a fluorine atom, a chlorine atom, a bromine atom, and an iodine atom.

Examples of the compound represented by Formula (1) are shown below.

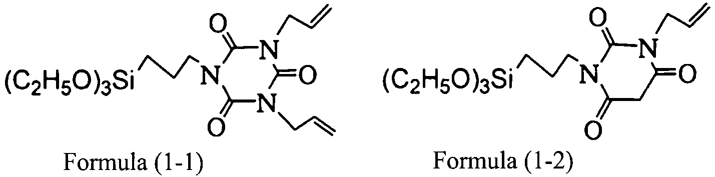

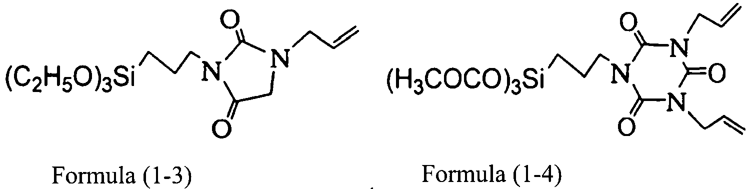

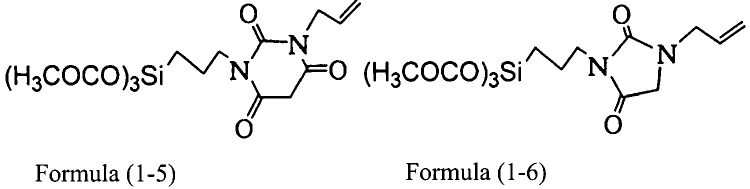

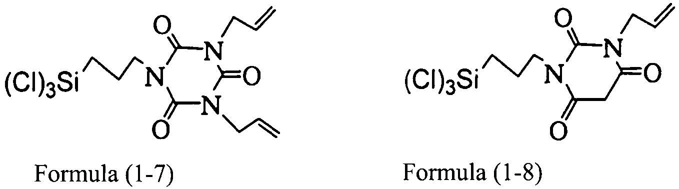

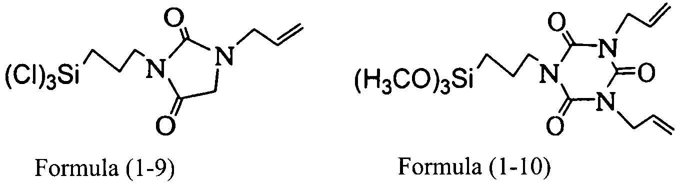

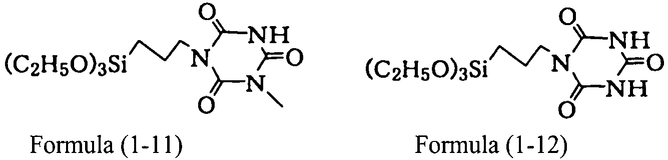

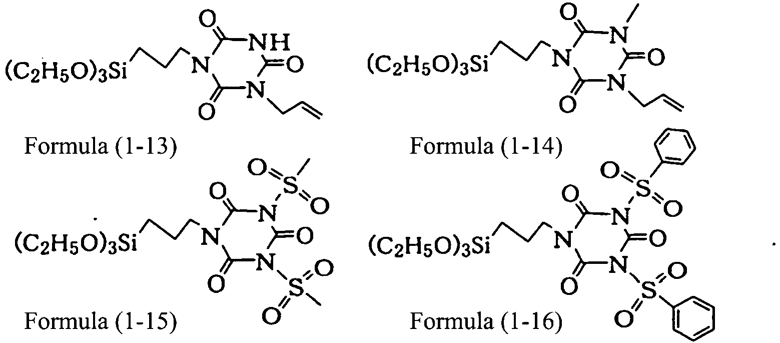

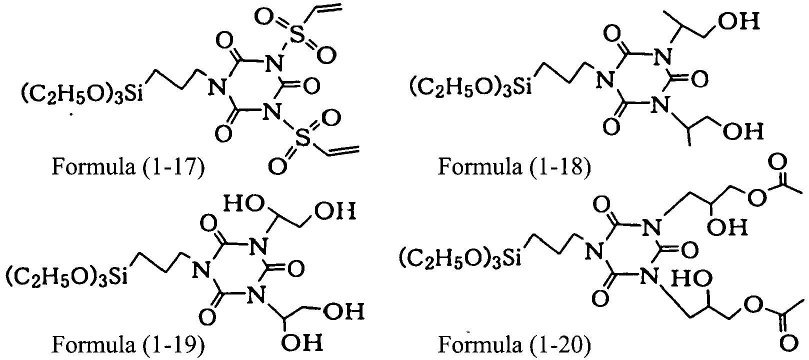

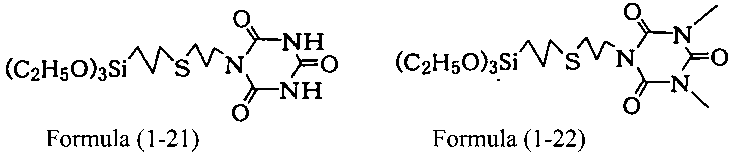

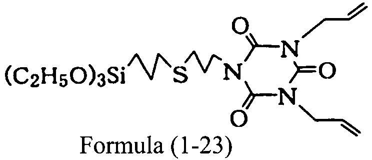

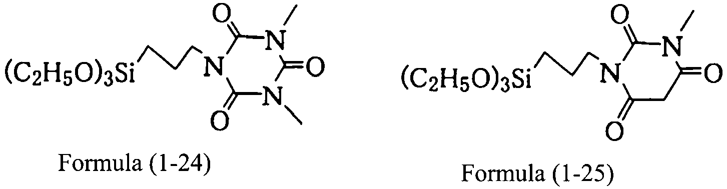

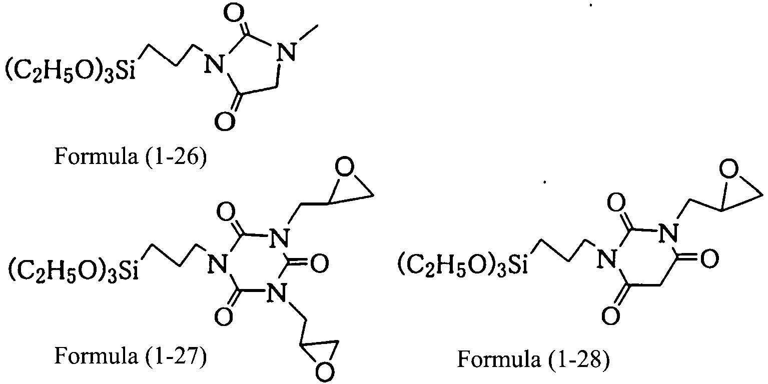

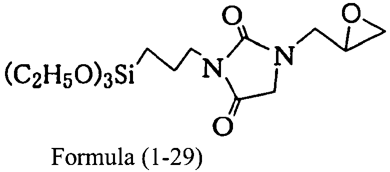

In the following examples, T is R³ in Formula (1).

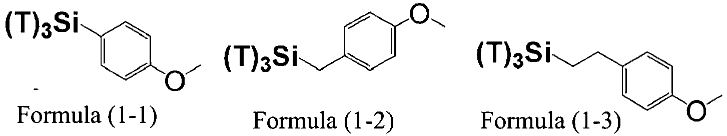

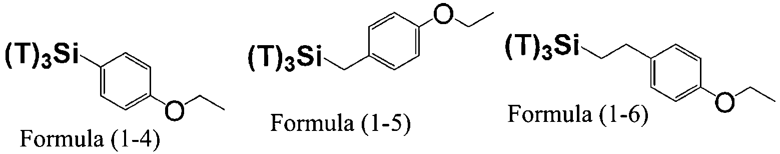

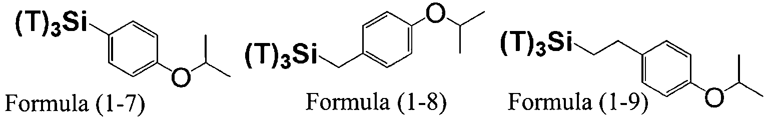

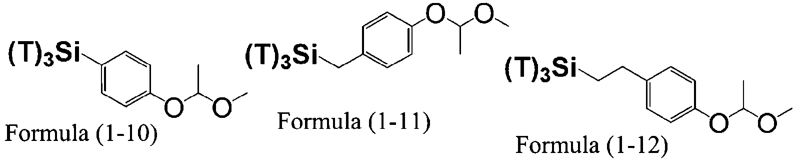

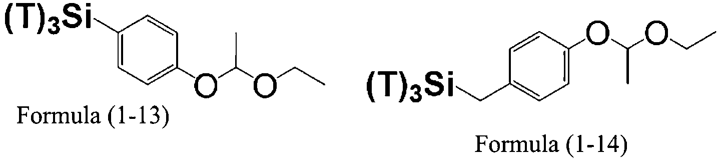

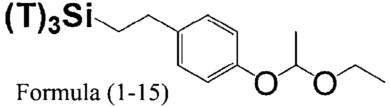

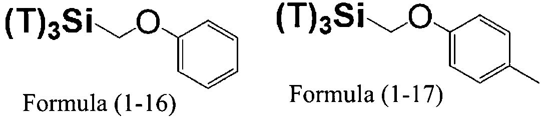

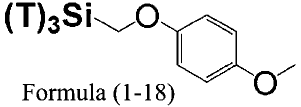

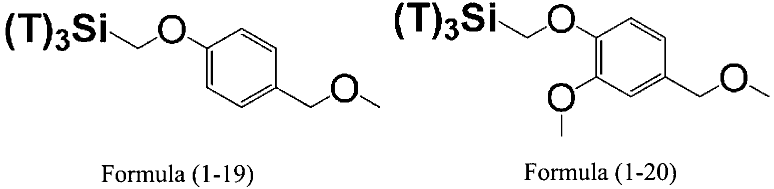

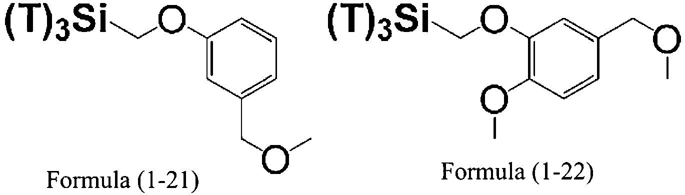

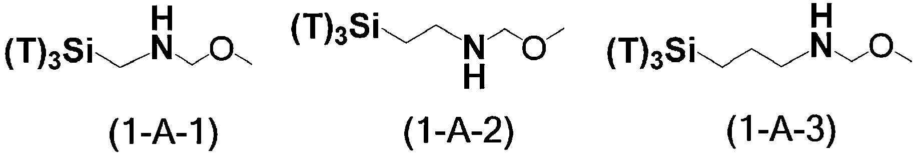

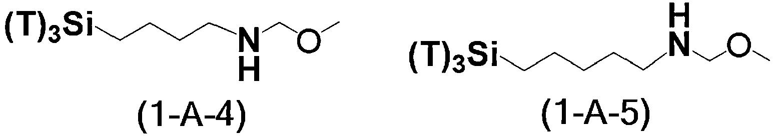

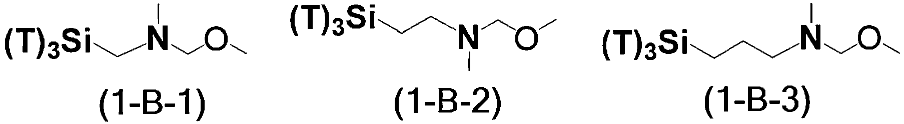

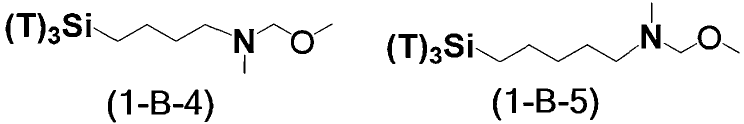

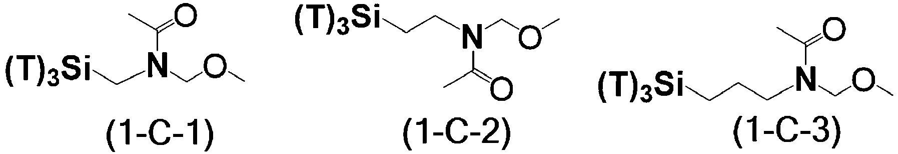

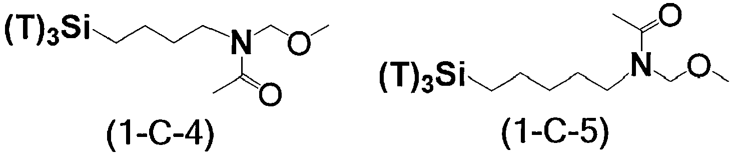

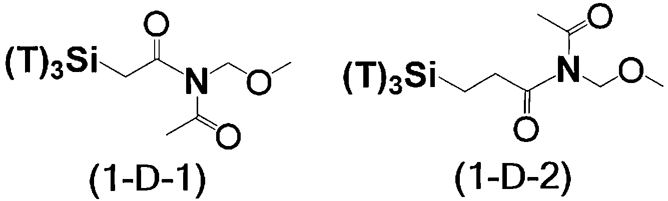

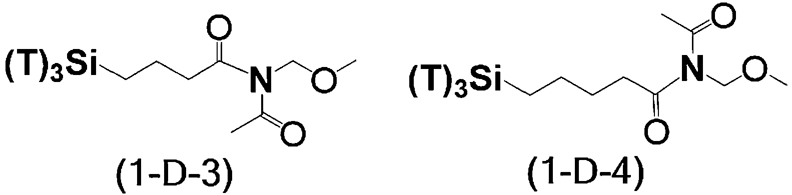

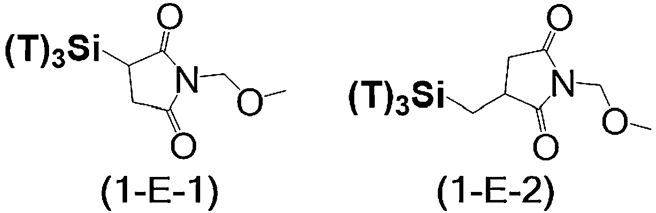

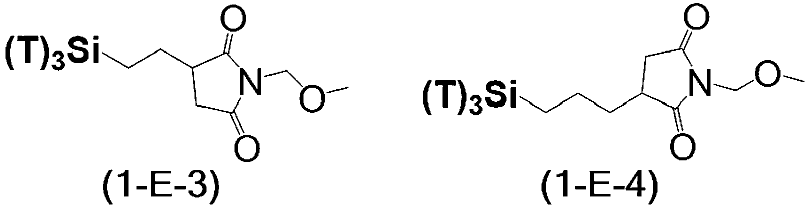

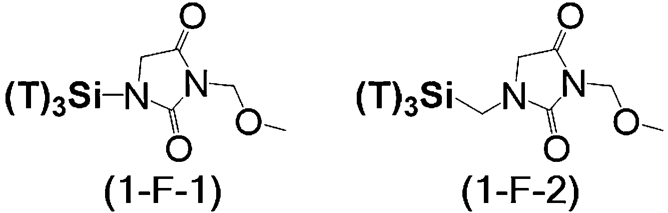

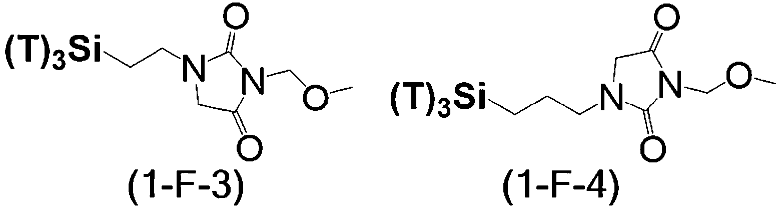

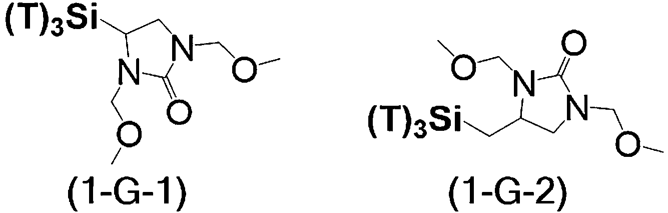

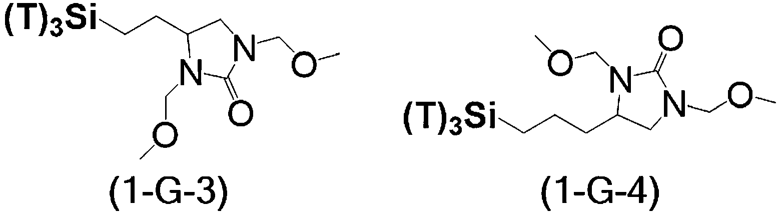

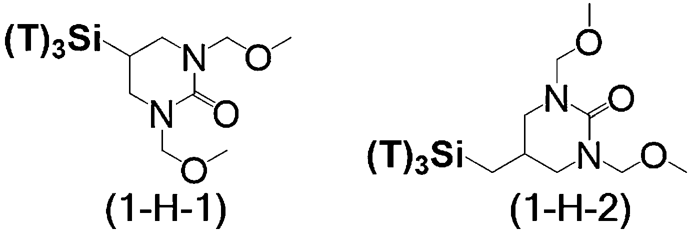

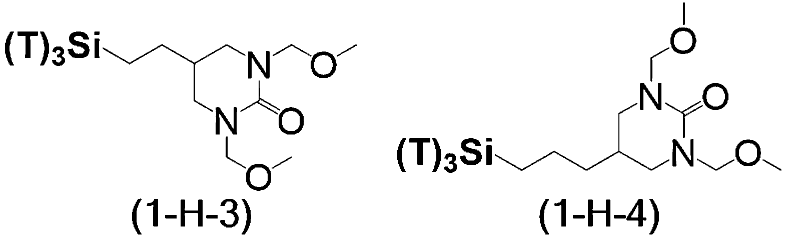

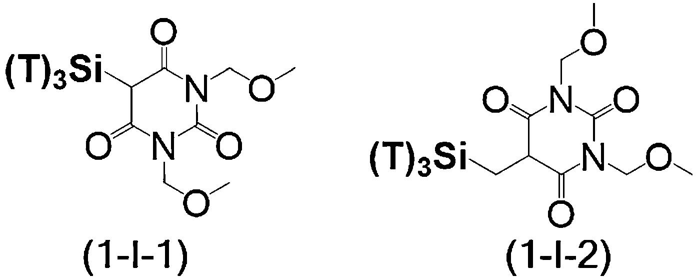

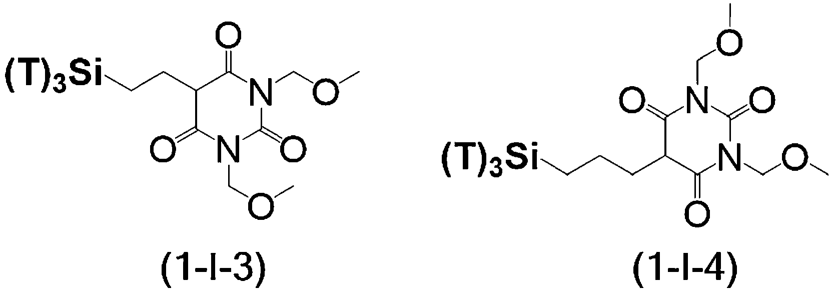

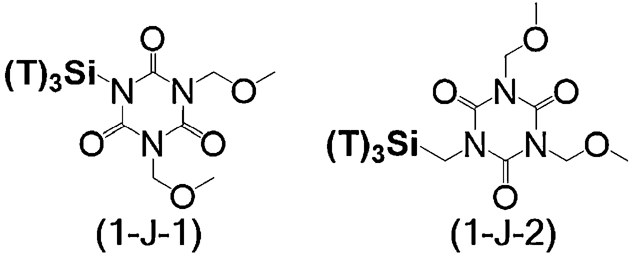

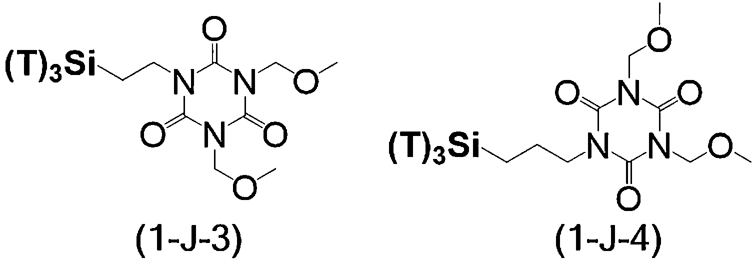

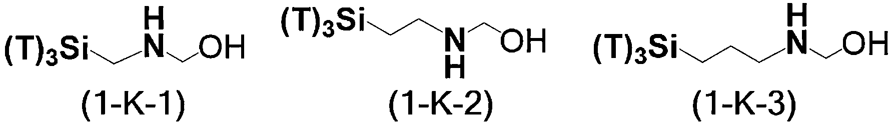

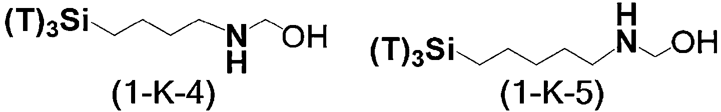

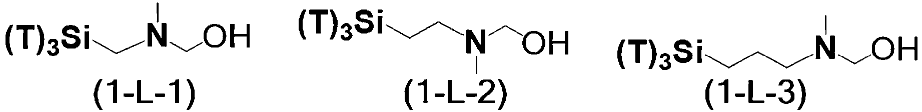

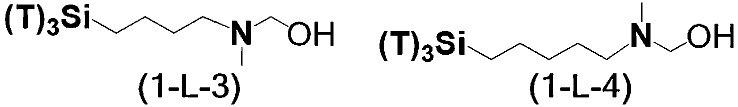

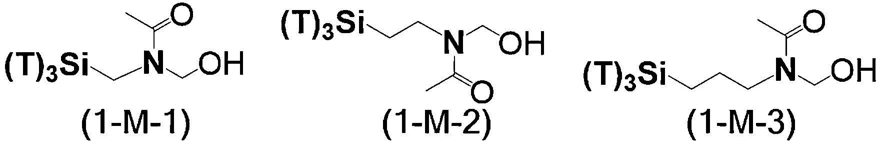

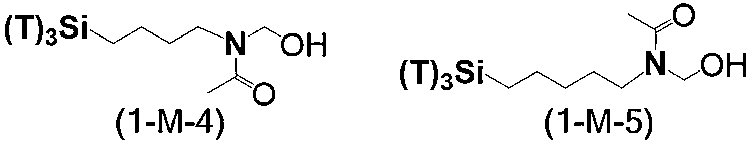

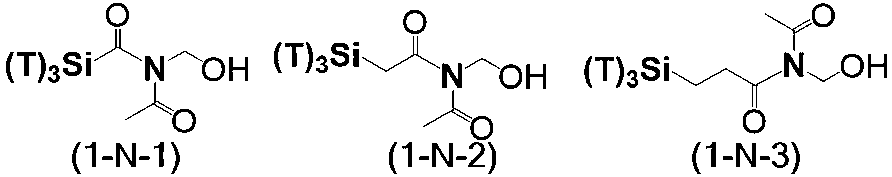

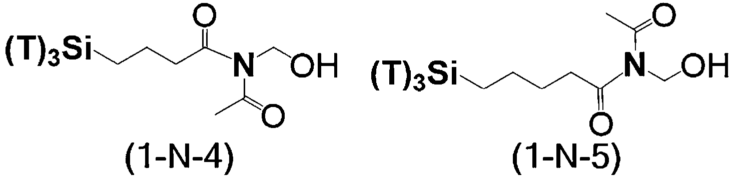

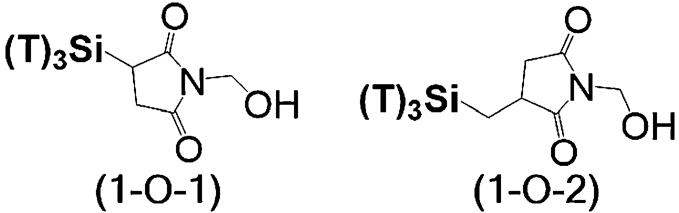

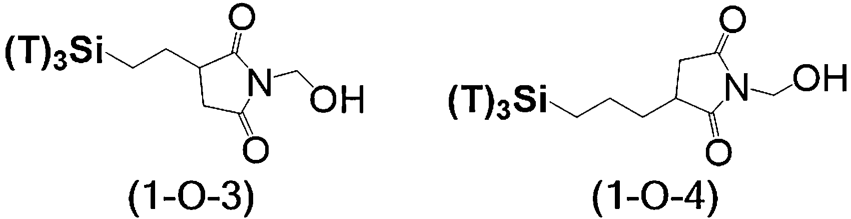

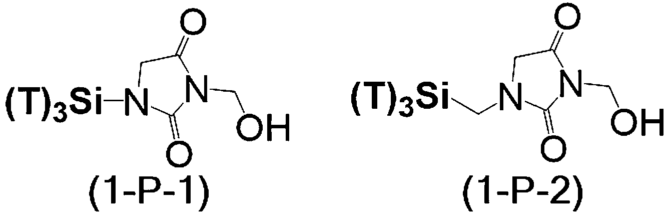

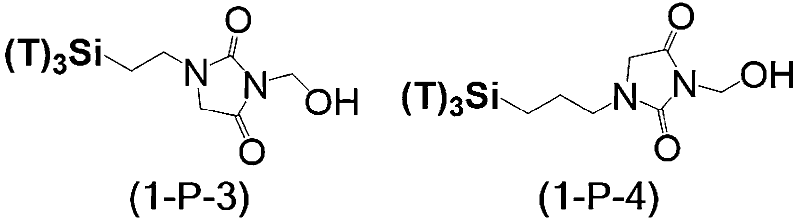

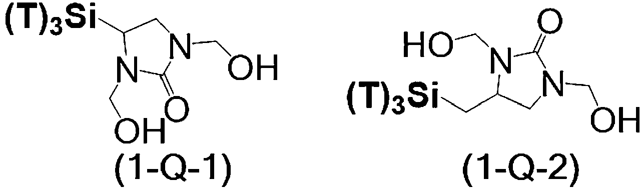

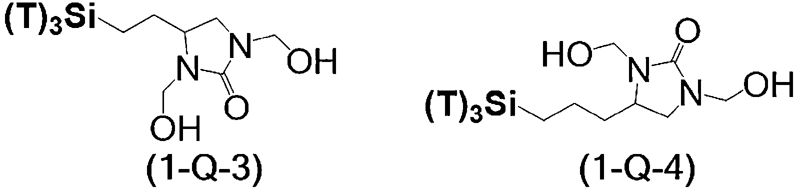

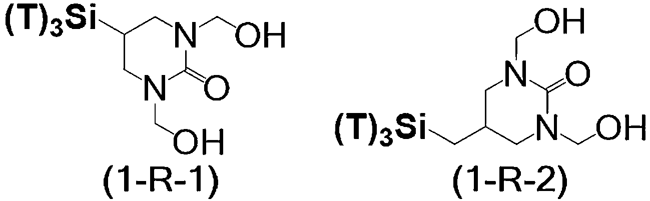

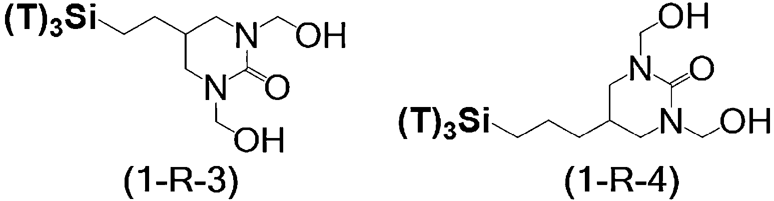

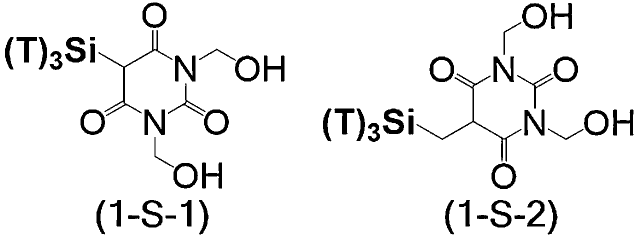

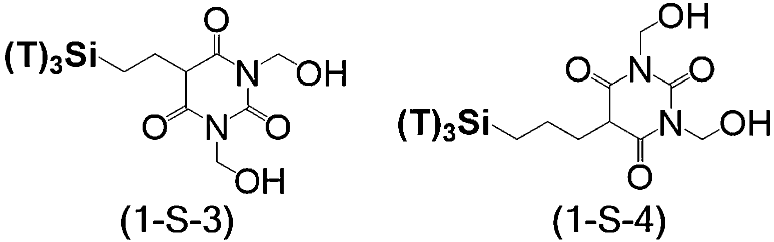

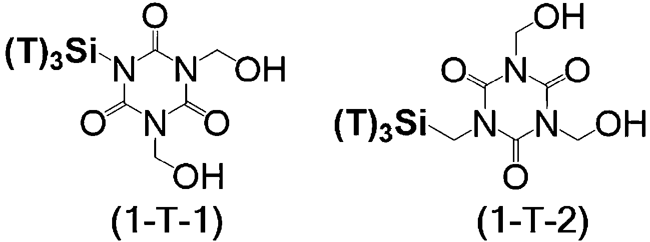

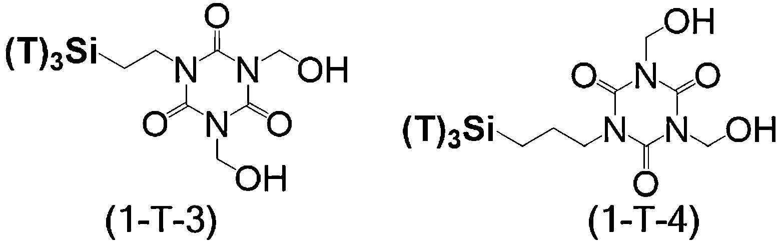

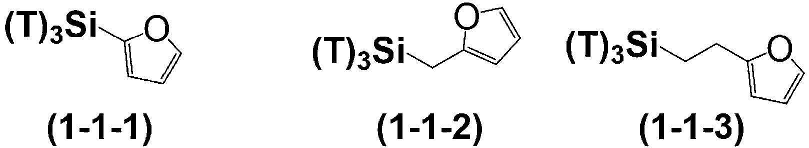

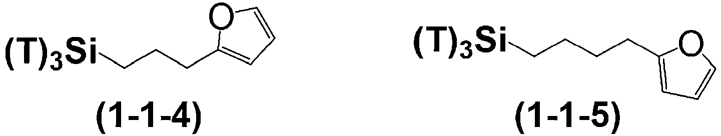

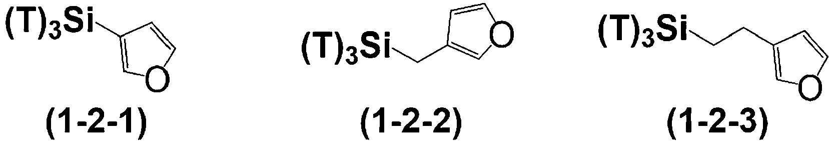

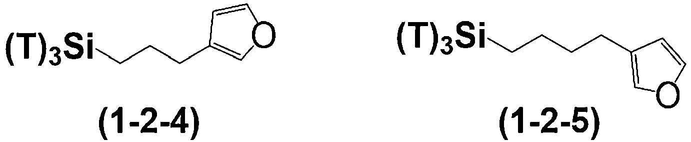

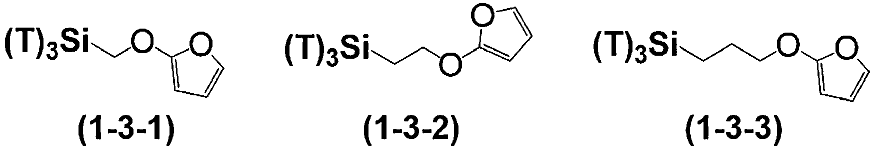

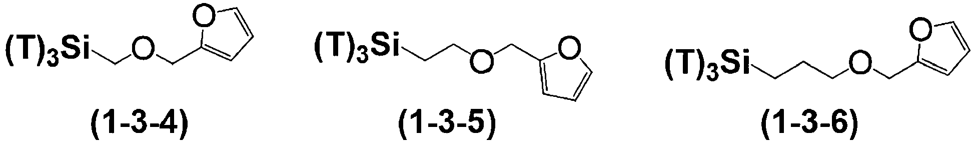

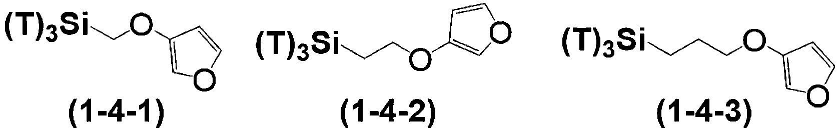

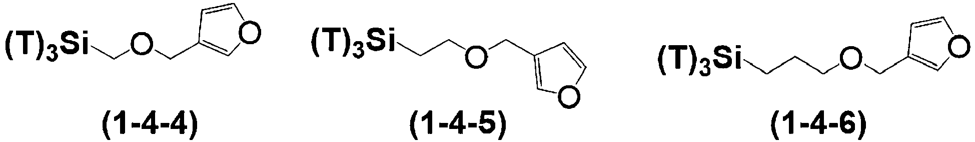

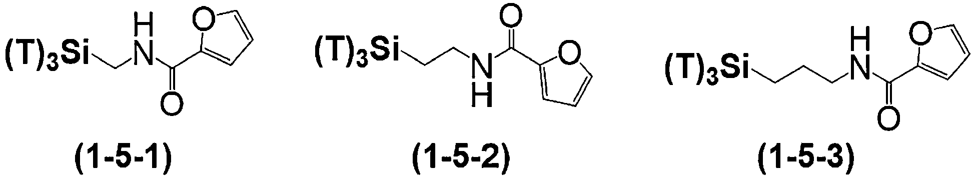

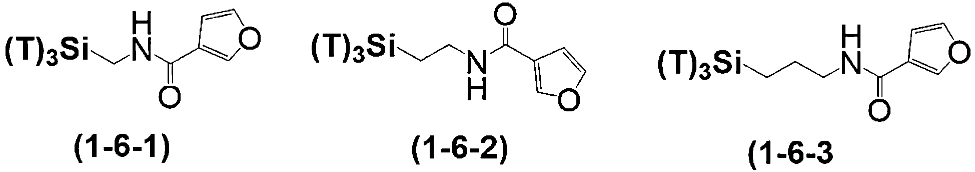

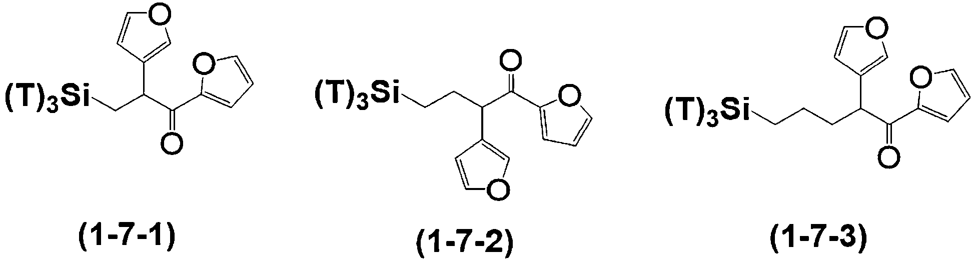

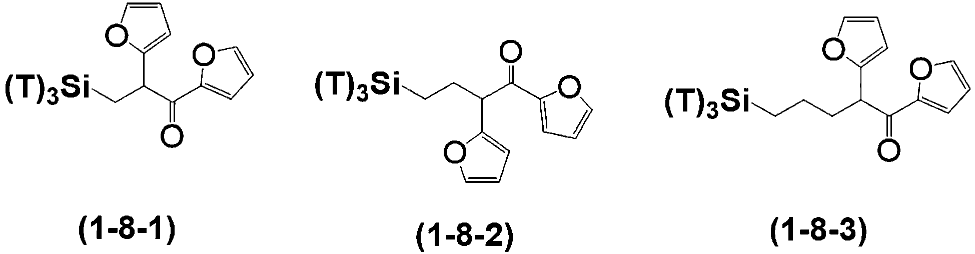

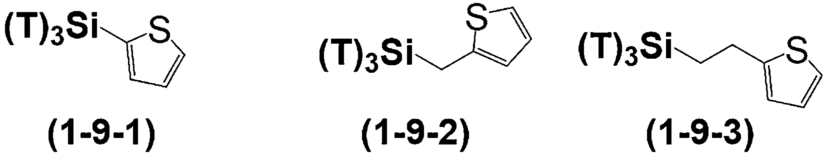

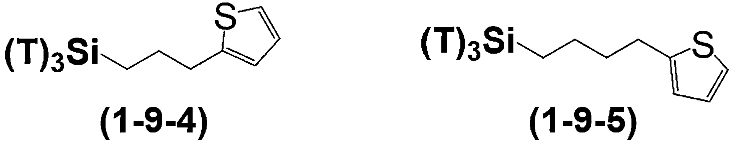

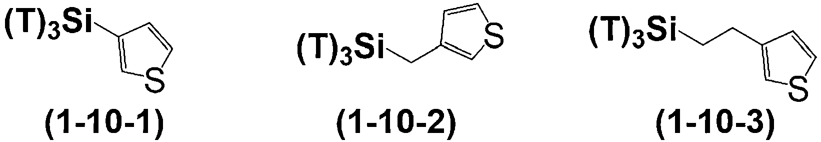

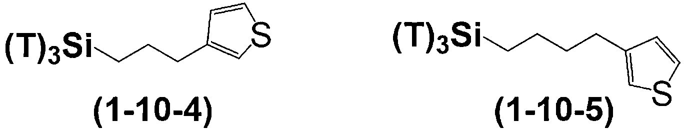

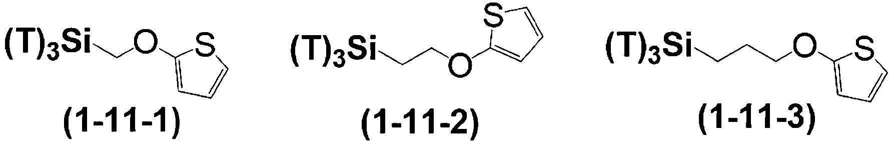

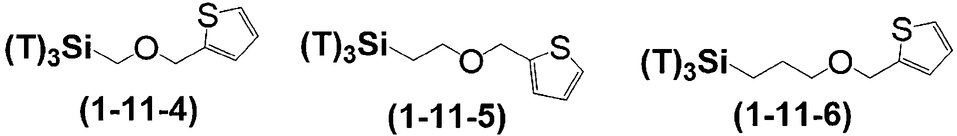

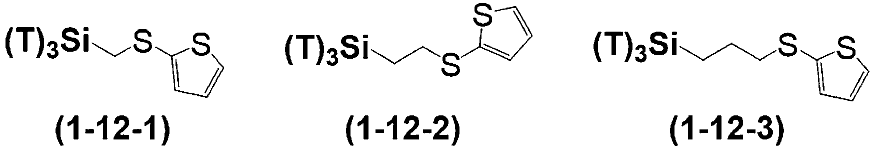

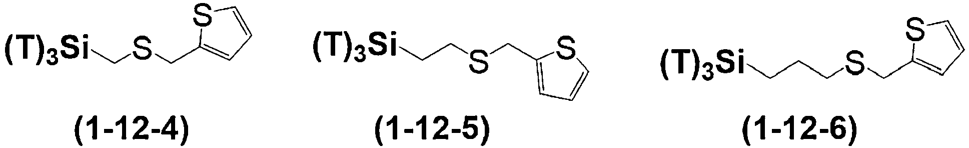

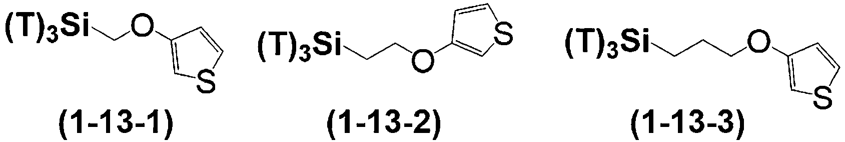

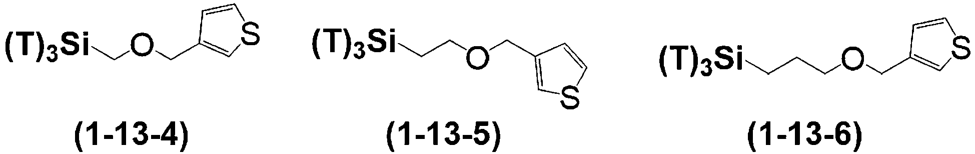

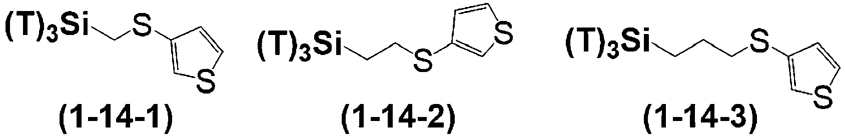

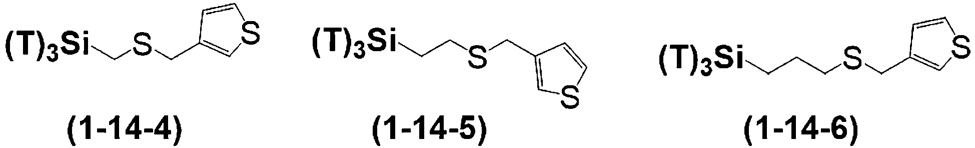

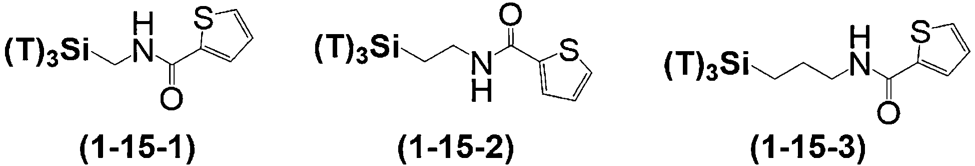

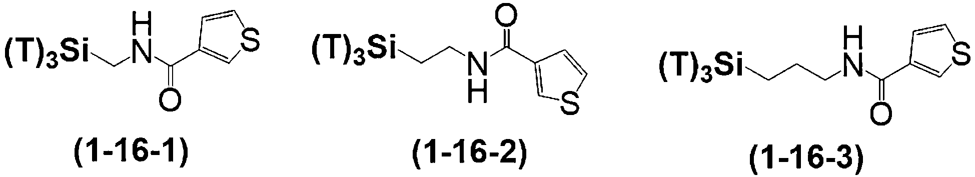

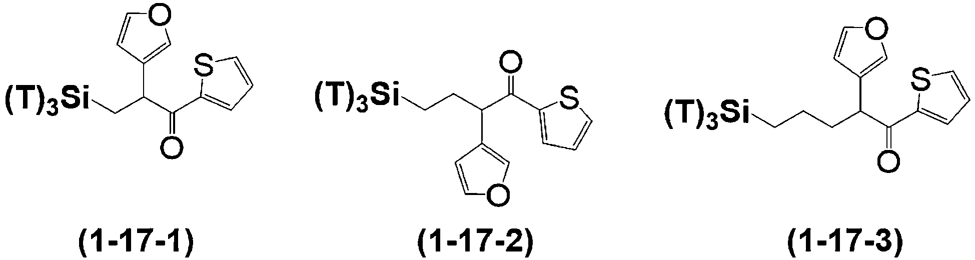

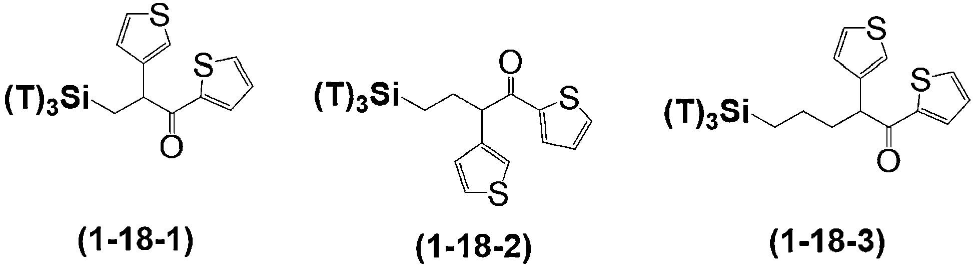

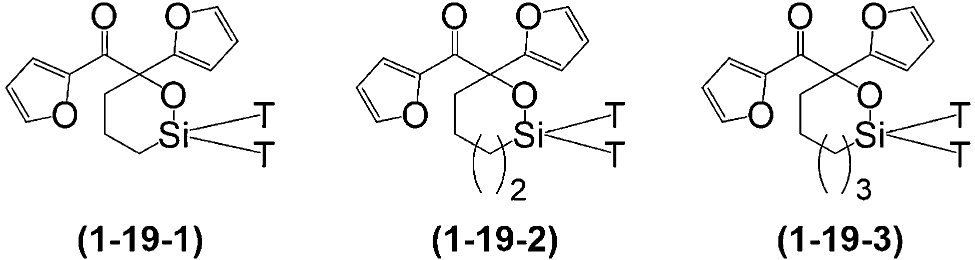

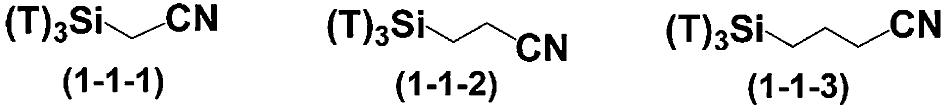

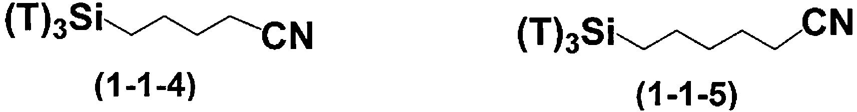

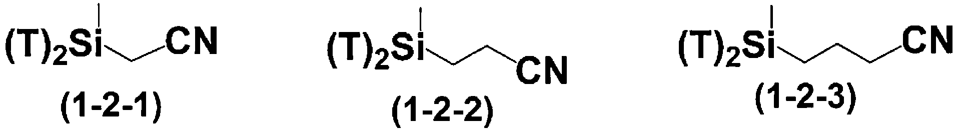

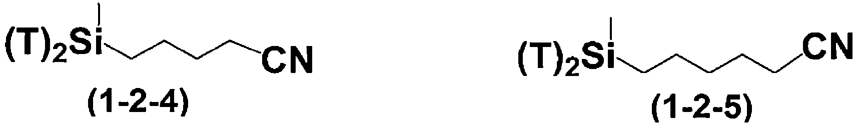

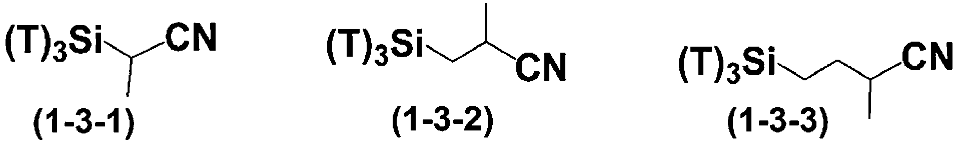

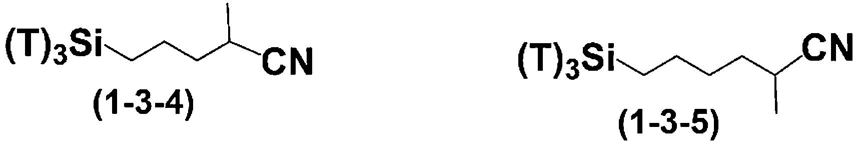

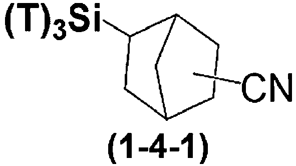

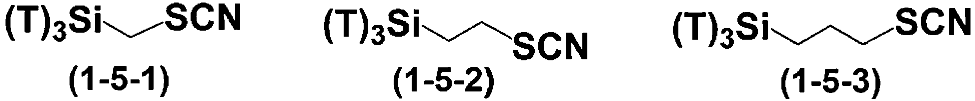

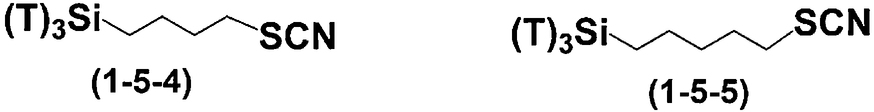

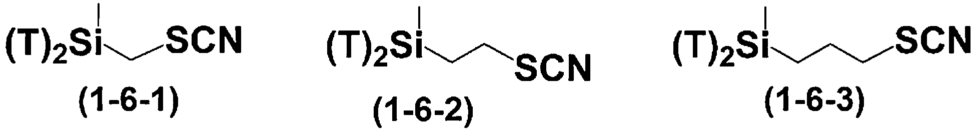

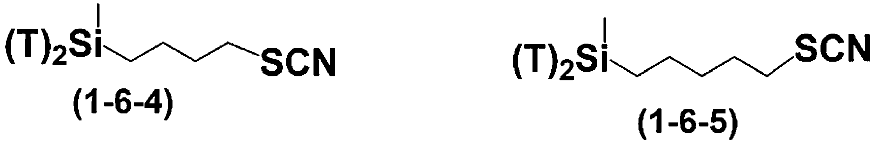

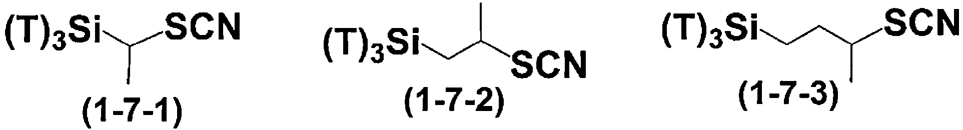

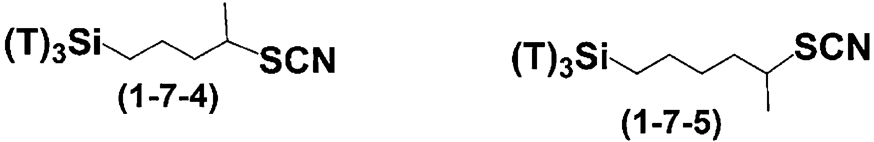

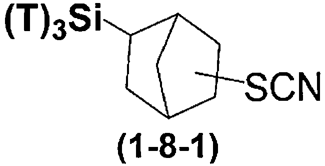

In the following examples, R is, for example, an alkyl group.

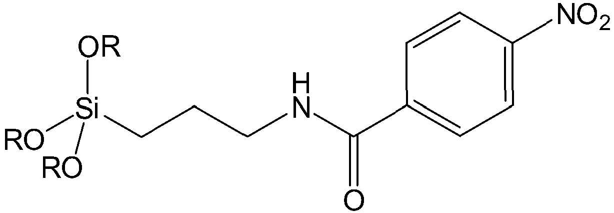

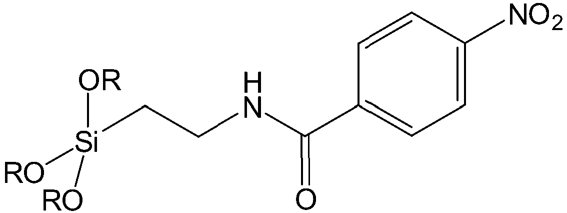

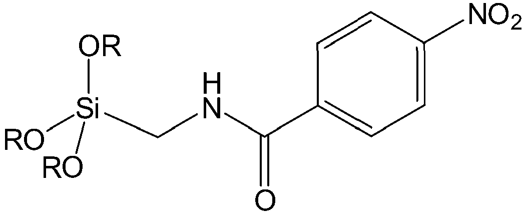

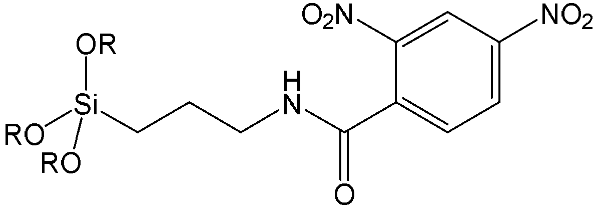

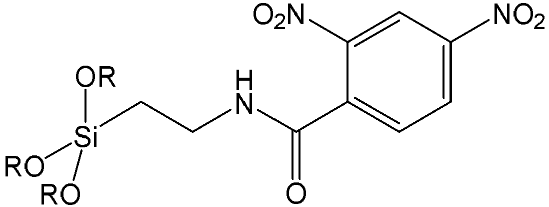

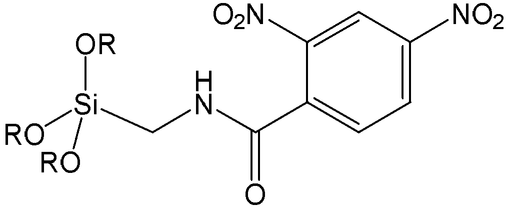

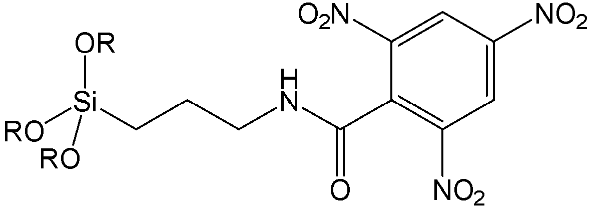

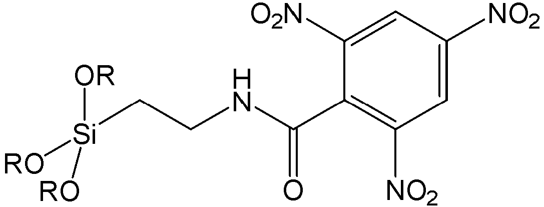

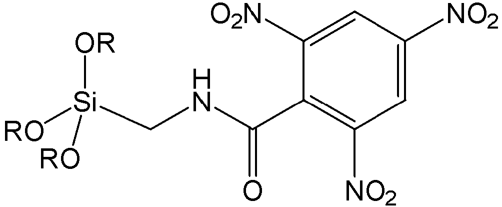

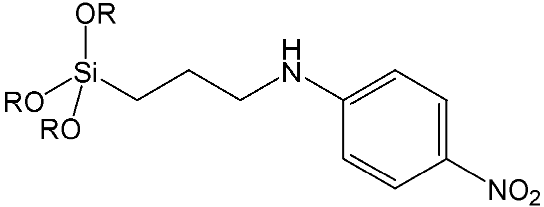

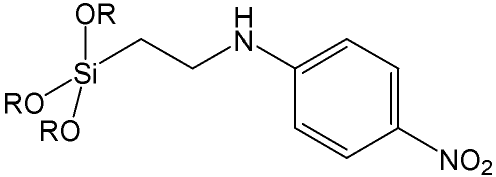

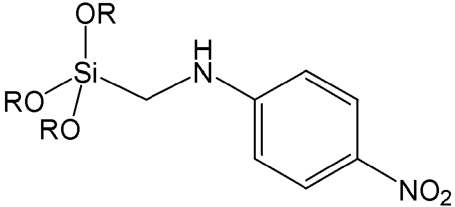

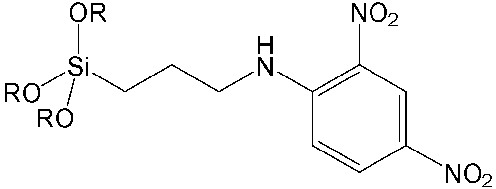

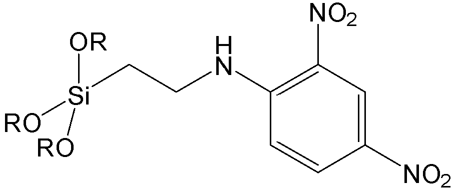

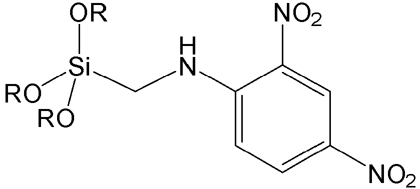

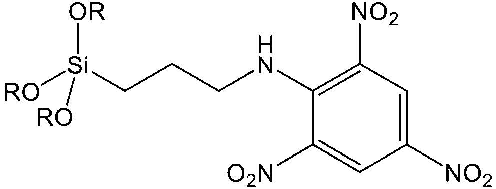

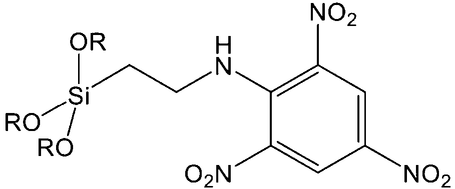

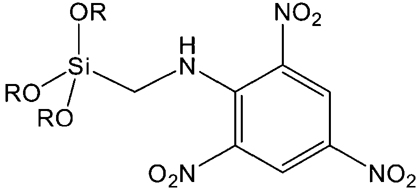

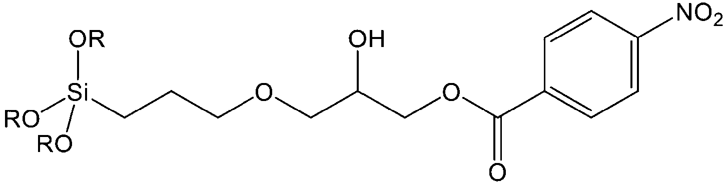

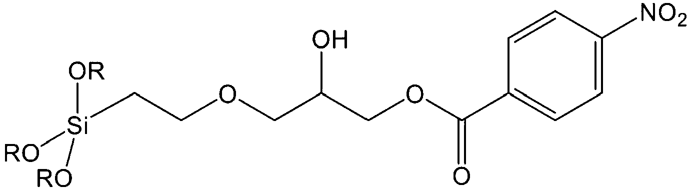

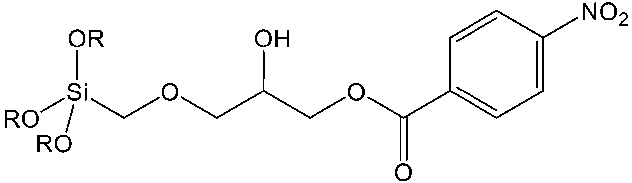

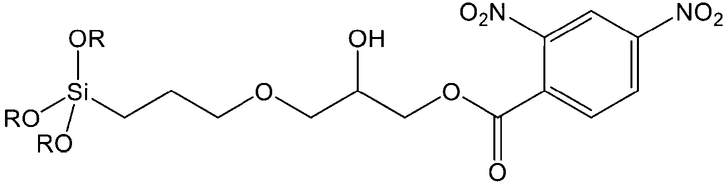

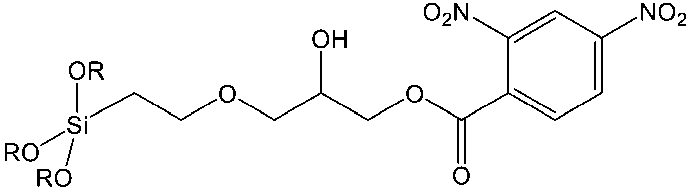

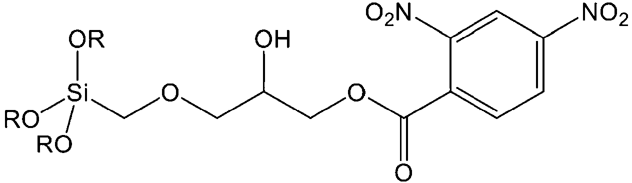

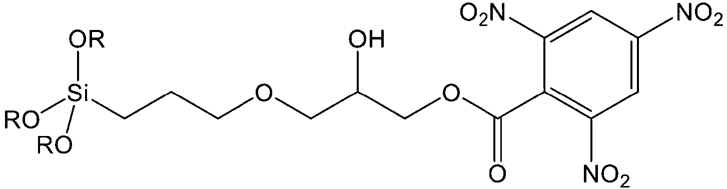

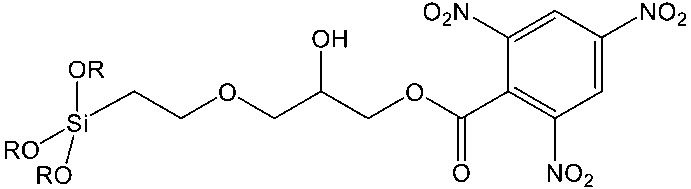

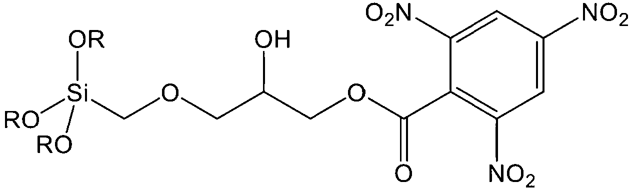

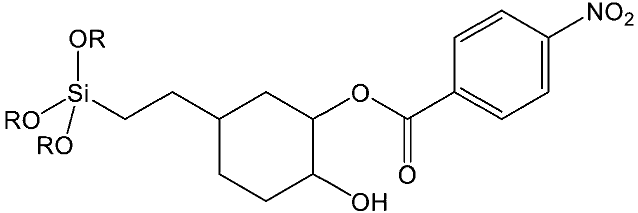

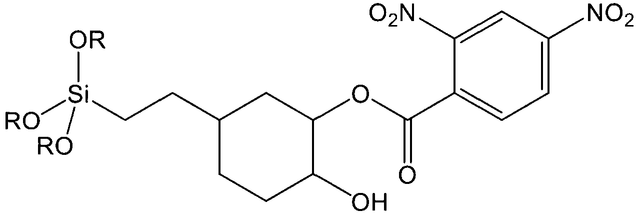

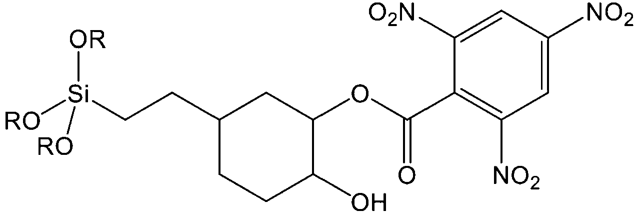

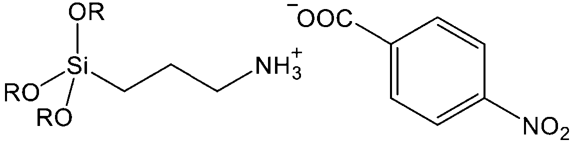

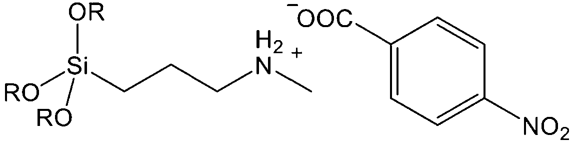

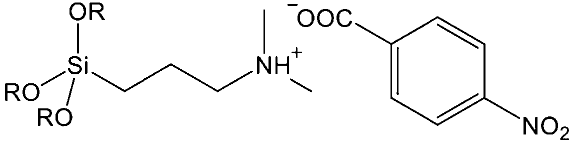

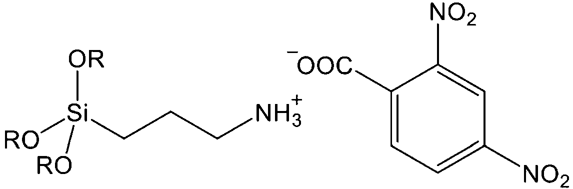

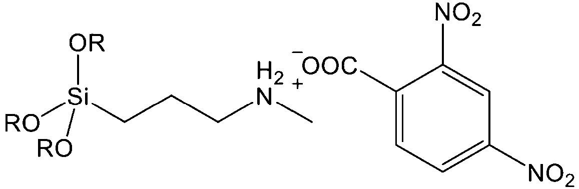

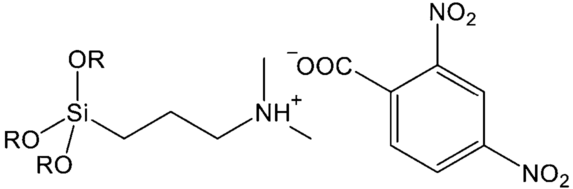

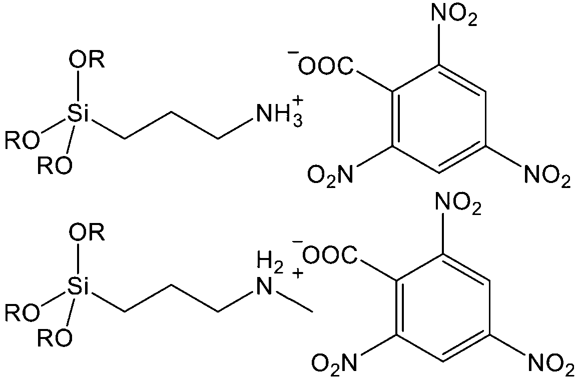

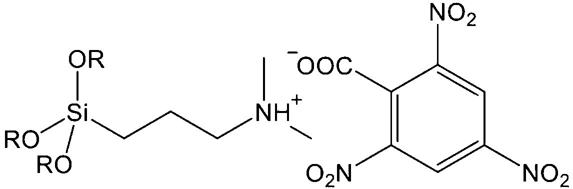

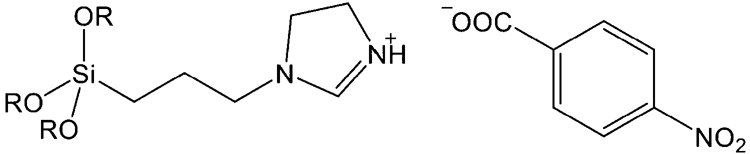

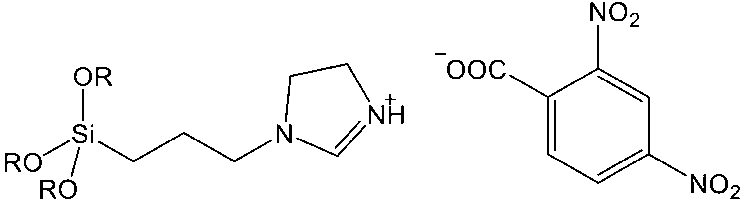

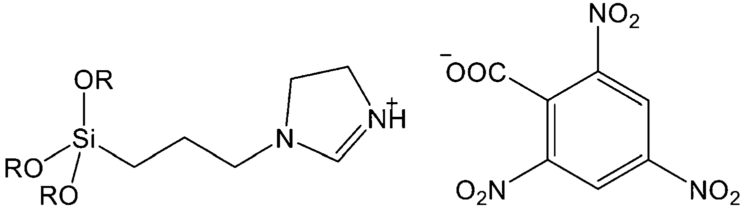

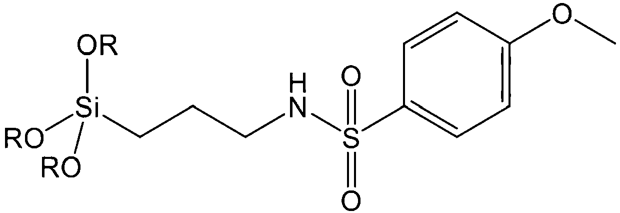

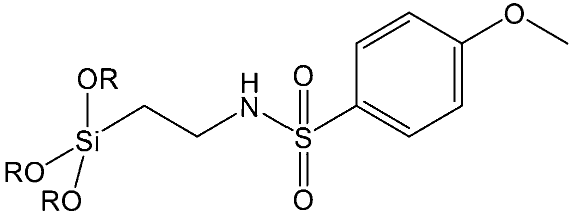

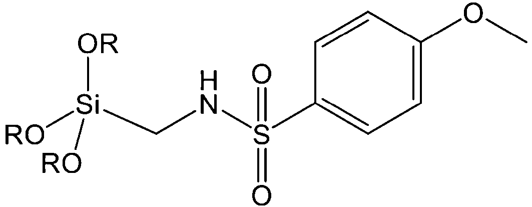

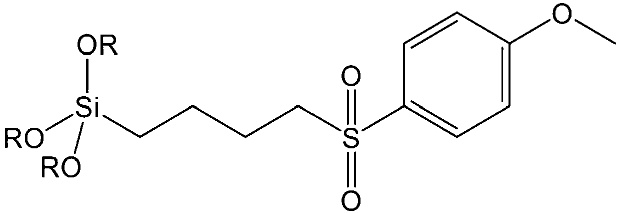

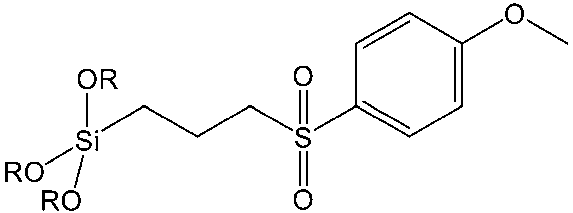

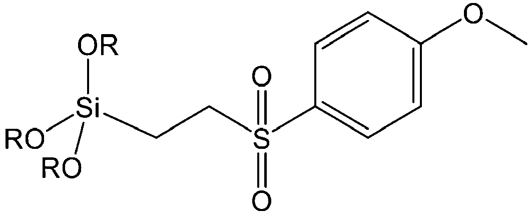

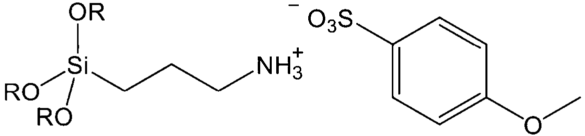

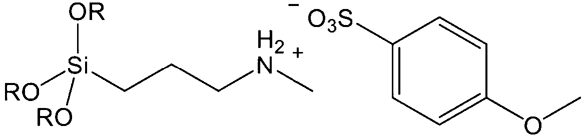

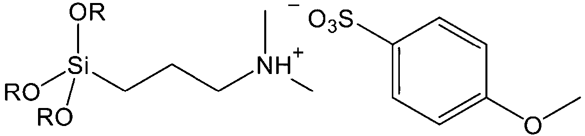

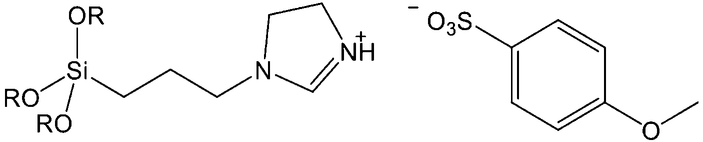

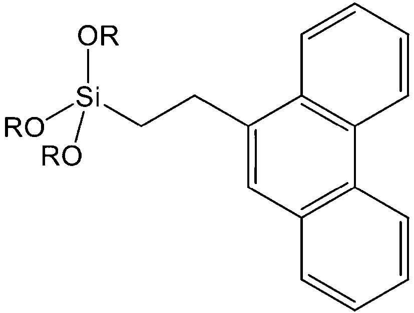

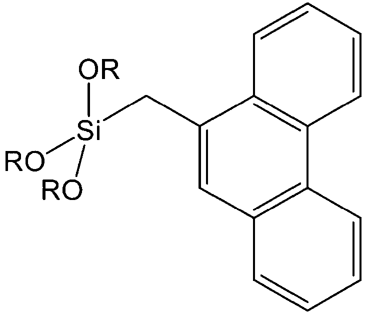

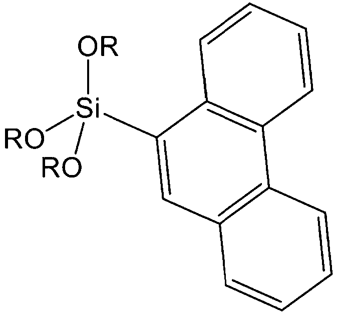

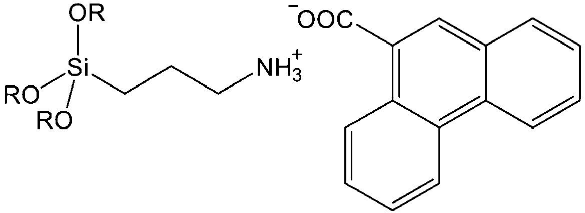

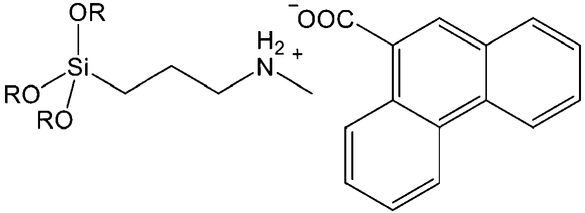

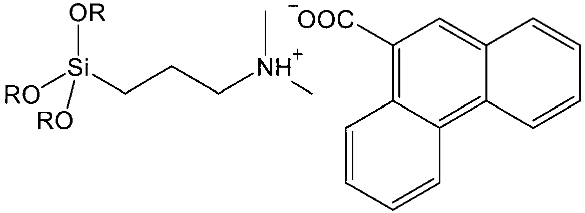

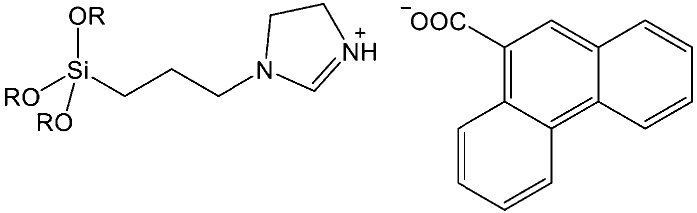

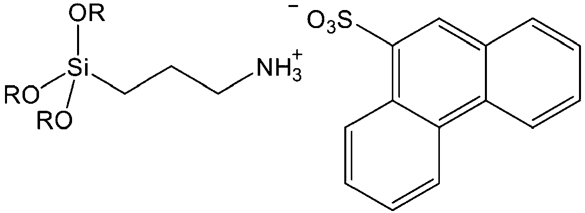

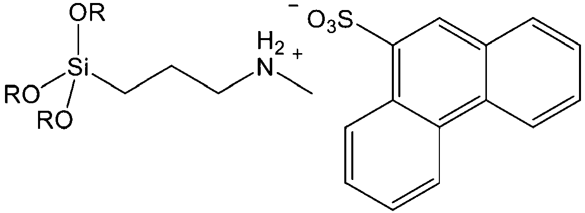

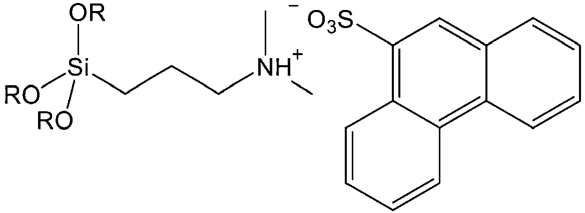

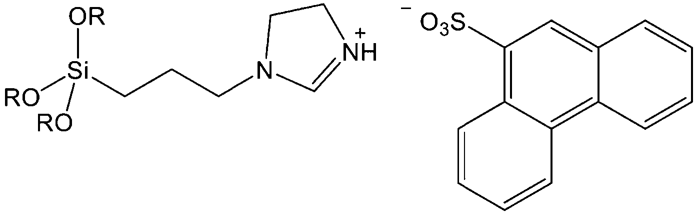

The following Ts are examples of a ring structure that R¹ may have. T=

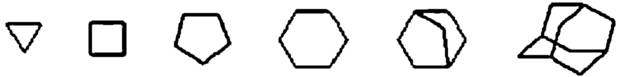

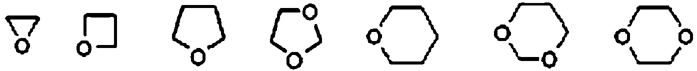

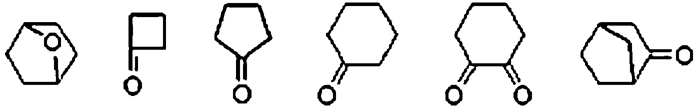

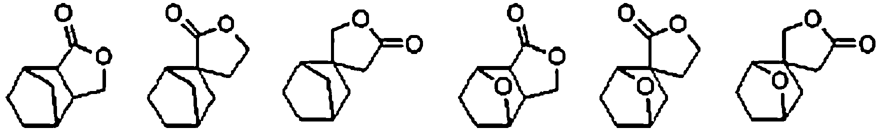

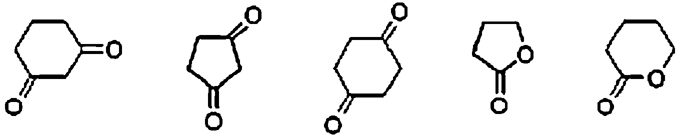

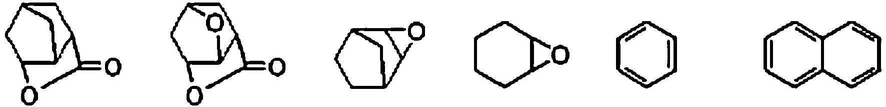

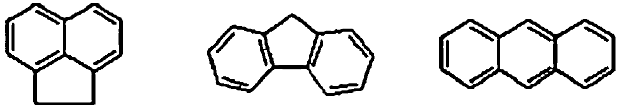

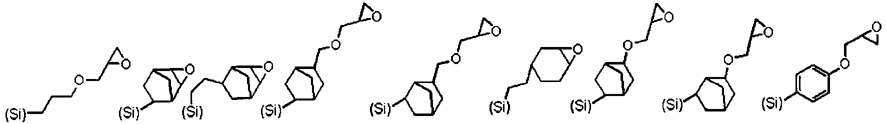

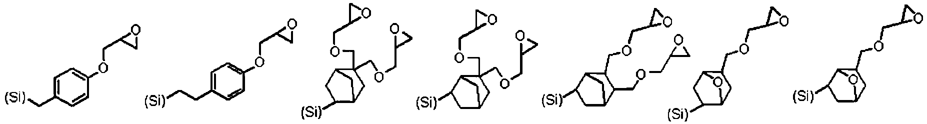

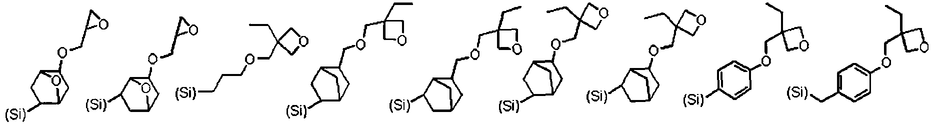

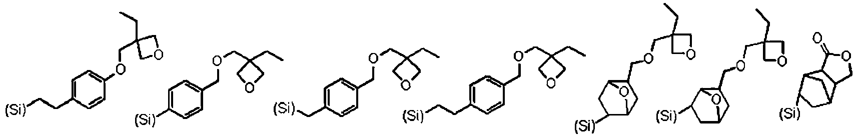

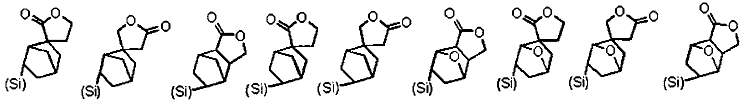

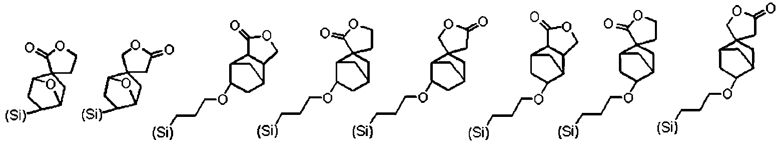

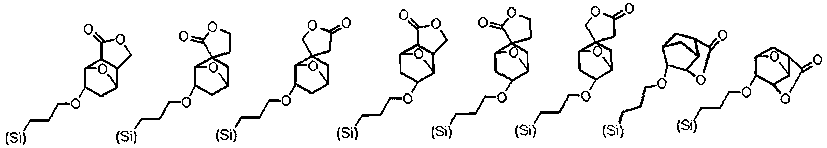

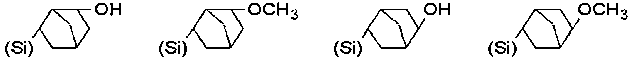

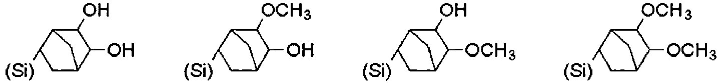

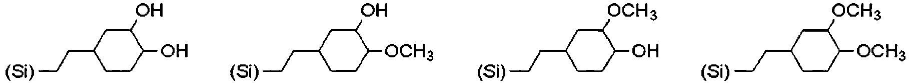

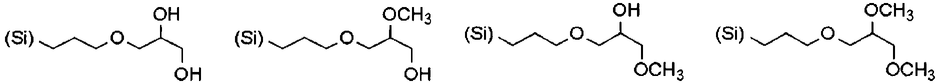

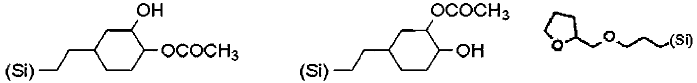

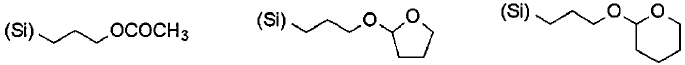

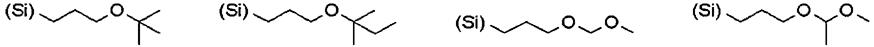

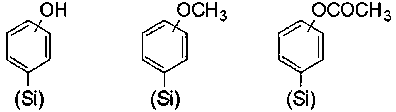

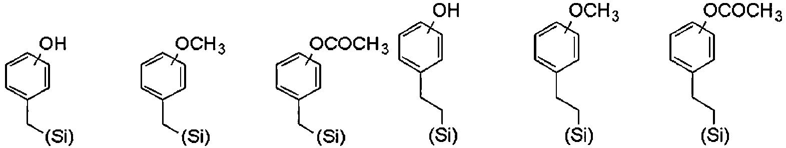

The compound represented by Formula (1) may be a commercially available product or a synthesized compound.

When R¹ represents the monovalent group represented by Formula (2), the compound represented by Formula (1) can be synthesized with reference to, for example, the method described in paragraphs [0034] to [0036] of WO 2011/102470 pamphlet.

When gasifying the compound represented by Formula (1), the gasification may be performed using the compound represented by Formula (1) itself, or may be performed using a solution in which the compound represented by Formula (1) is dissolved in an organic solvent.

The organic solvent to be used is not particularly limited, and examples thereof include esters, ethers, and hydrocarbons.

The gaseous compound represented by Formula (1) is employed in a step of forming a thin film, and, for that purpose, the gaseous compound is introduced into, for example, a film formation chamber.

Examples of a method of introducing the gaseous compound represented by Formula (1) into the film formation chamber include a gas transportation method and a liquid transportation method.

The gas transportation method is a method of vaporizing the compound represented by Formula (1) into a gas (vapor) by heating the raw material container containing the compound represented by Formula (1) and/or by depressurizing the raw material container, and introducing the gas into the film formation chamber with a substrate disposed therein, along with, when necessary, a carrier gas such as argon, nitrogen, or helium.

The liquid transportation method is a method of transporting the compound represented by Formula (1) in a liquid or solution state to the vaporization chamber, vaporizing the compound represented by Formula (1) into a gas (vapor) by heating the vaporization chamber and/or by depressurizing the vaporization chamber, and introducing the gas into the film formation chamber.

### Formation of Thin Film

This step is a step of bringing the gaseous compound represented by Formula (1) into contact with a surface of the substrate, and further chemically reacting the compound represented by Formula (1) to form a thin film having a Si-R¹ group of the compound represented by Formula (1) on the surface of the substrate.

This step is preferably performed in the film formation chamber.

In a preferred embodiment, this step is a step of bringing the gaseous compound represented by Formula (1) into contact with the surface of the substrate in the film formation chamber under reduced pressure, and further chemically reacting the compound represented by Formula (1) to form a thin film having a Si-R¹ group of the compound represented by Formula (1) on the surface of the substrate.

In this step, a pressure when the film formation chamber is depressurized is not particularly limited, and is, for example, from 1 to 10000 Pa. From the viewpoint of suitably vaporizing the compound represented by Formula (1), the pressure is preferably 5000 Pa or less, more preferably 3000 Pa or less, and even more preferably 2500 Pa or less. A degree of depressurization is appropriately set in consideration of the heating temperature.

An amount of the gaseous compound represented by Formula (1) to be introduced into the film formation chamber is not particularly limited and may be appropriately determined in consideration of, for example, the desired film thickness.

A method of bringing the gaseous compound represented by Formula (1) into contact with the surface of the substrate is not particularly limited, and examples thereof include a method of spraying the gaseous compound represented by Formula (1) that has been introduced into the film formation chamber onto the surface of the substrate from a direction having a predetermined angle with respect to the surface of the substrate (for example, the perpendicular direction).

When the gaseous compound represented by Formula (1) is brought into contact with the surface of the substrate, the substrate and/or the atmosphere in the film formation chamber is preferably heated from the viewpoint of promoting the formation of the thin film. A heating temperature of the substrate and/or the atmosphere in the film formation chamber is usually from 25 to 200°C. From the viewpoint of suitably vaporizing the compound represented by Formula (1), the heating temperature is preferably 50°C or higher, more preferably 70°C or higher, even more preferably 90°C or higher, and still more preferably 110°C or higher. The heating temperature is appropriately set in consideration of whether depressurization is adopted and, when depressurization is adopted, the degree of depressurization.

In the film formation chamber, the substrate is placed on, for example, a support pedestal. The substrate may be heated, for example, by heating the film formation chamber or by heating the support pedestal.

The size, material, and structure of the film formation chamber are not particularly limited and may be appropriately determined in consideration of the size of the substrate to be used, the heating temperature, and the like.

### Substrate

The substrate is not particularly limited as long as it is a target for formation of the thin film having a Si-R¹ group on its surface.

The surface of the substrate may be planar, or may have a three-dimensional structure such as a trench structure.

The substrate may have a single-layer structure or a multi-layer structure.

The substrate may be, for example, a silicon wafer single-layer substrate, or a multi-layer substrate in which a single or multiple layers of an organic film or an inorganic film are formed on a silicon wafer.

Examples of the substrate include a silicon wafer substrate, a silicon/silicon dioxide-covered substrate, a silicon nitride substrate, a glass substrate, an ITO substrate, a polyimide substrate, and a substrate covered with a low-dielectric-constant material (low-k material). The substrate can also be those in which a single or multiple layers of an organic film or an inorganic film are formed on these substrates. An example of the organic film or the inorganic film is, for example, an anti-reflective film.

The substrate disposed in the film formation chamber is preferably surface-treated in advance.

Examples of the surface treatment include washing with an organic solvent and a treatment with UV-ozone.

In this step, the compound represented by Formula (1) is chemically reacted.

An example of the chemical reaction is a chemical reaction between the substrate and R³. The chemical reaction is, for example, a condensation reaction between a hydroxy group on the surface of the substrate and an Si-R³ group. When R³ is an alkoxy group or an acyloxy group, for example, two types of chemical reactions may occur during the chemical reaction: one in which a hydroxy group on the surface of the substrate and the Si-R³ group directly undergo a condensation reaction; and the other in which the Si-R³ group is converted into an Si-OH group, and then the Si-OH group and the hydroxy group on the surface of the substrate undergo a condensation reaction.

Another example of the chemical reaction is the formation of a siloxane bond between two compounds represented by Formula (1), the siloxane bond involving R³ of each of the compounds represented by Formula (1).

The thin film having a Si-R¹ group is formed on the surface of the substrate by chemically reacting the gaseous compound represented by Formula (1) on the surface of the substrate.

The film thickness of the thin film having a Si-R¹ group is not particularly limited, and is, for example, from 0.1 to 10 nm, preferably from 0.5 to 8 nm, and more preferably from 0.7 to 5 nm.

The thickness of the thin film can be measured by, for example, an optical film thickness measuring device NanoSpec/AFT5100 (available from Nanometrics Inc.), an ellipsometric film thickness measuring device ASET-F5 film thickness measuring device (available from KLA Corporation), an ellipsometric film thickness measuring device RE3100/3500 (available from SCREEN Holdings Co., Ltd.), or an ellipsometric film thickness measuring device VUV-VASE (available from J.A. Woollam).

### Retrieving of Substrate

This step is a step of retrieving, from the film formation chamber, the substrate including the thin film having the Si-R¹ group, the thin film being formed on the surface of the substrate.

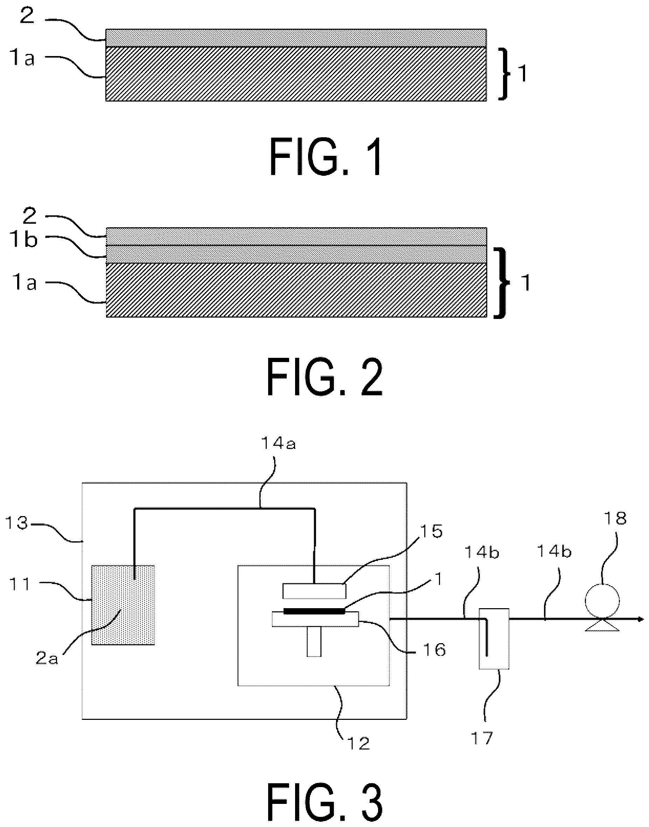

In the steps illustrated in FIG. 3 of JP 2014-129606 A, as described in paragraph [0043], the surface having a hydroxyl group is exposed to 3-[(1,3-dimethylbutylidene)amino]propyltriethoxysilane (PS). The PS bonds to the surface via a siloxane bond. A protecting group masks the -NH₂ functional group until the protecting group is removed. When the PS surface is exposed to water, the protecting group is removed. Water reacts with the imine moiety, thereby releasing 4-methyl-2-pentanone. As a result of the reaction, primary amines remain on the surface.

In JP 2014-129606 A, there is no explicit indication that these steps are performed in a film formation chamber, but these steps are usually performed as a series of steps in a film formation chamber.

Meanwhile, in the method of manufacturing a substrate with a thin film according to an embodiment of the present invention, when the thin film having a Si-R¹ group is formed in the film formation chamber, no further treatment is performed on the thin film in the film formation chamber, and the substrate including the thin film having a Si-R¹ group having been formed on the surface thereof is retrieved from the film formation chamber.

The method of retrieving the substrate from the film formation chamber is not particularly limited and may be appropriately determined.

The application of the thin film produced is not particularly limited and may be appropriately determined. For example, the thin film can be used as a resist underlayer film, an anti-reflective film, a photo-reactive resist film/electron-beam-reactive resist film, or a self-assembled film.

Here, an example of the substrate with a thin film will be described with reference to drawings.

FIG. 1 is a schematic cross-sectional view of an example of the substrate with a thin film.

The substrate with a thin film in FIG. 1 has a substrate 1 and a thin film 2. The substrate 1 is a single-layer substrate composed of a silicon wafer 1a. The thin film 2 is formed on the surface of the silicon wafer 1a.

Another example of the substrate with a thin film will be described with reference to drawings.

FIG. 2 is a schematic cross-sectional view of another example of the substrate with a thin film.

The substrate with a thin film in FIG. 2 has a substrate 1 and a thin film 2. The substrate 1 is a multi-layer substrate including a silicon wafer 1a and an organic underlayer film 1b. The thin film 2 is formed on the surface of the organic underlayer film 1b.

Next, an example of the method of manufacturing a substrate with a thin film will be described using a manufacturing device for the substrate with a thin film.

First, an example of the manufacturing device will be described. FIG. 3 is a schematic cross-sectional view of an example of the manufacturing device for the substrate with a thin film.

The manufacturing device includes a raw material container 11, a film formation chamber 12, a heater 13, pipes 14a and 14b, a discharge port 15, a support pedestal 16, a trap 17, and a vacuum pump 18.

The raw material container 11, the film formation chamber 12, and the pipe 14a are covered by the heater 13.

The support pedestal 16 that is configured to support the substrate 1 is disposed in an internal space of the film formation chamber 12.

The internal space of the film formation chamber 12 is depressurized by the vacuum pump 18.

In order to prevent the vaporized gas discharged from the film formation chamber 12 by the vacuum pump 18 from reaching the vacuum pump 18, the trap 17 for trapping the vaporized gas is disposed in the middle of the pipe 14b between the film formation chamber 12 and the vacuum pump 18.

An example of the method of manufacturing a substrate with a thin film using the manufacturing device will be described below.

First, the compound represented by Formula (1) is placed in the raw material container 11. When being placed in the raw material container 11, the compound represented by Formula (1) may be liquid or solid at normal temperature and normal pressure.

Next, by heating the raw material container 11 to a predetermined temperature using the heater 13 while reducing the pressure in the raw material container 11, the compound represented by Formula (1) in the raw material container 11 is turned into a gas 2a.

Next, the resulting gas 2a is introduced into the film formation chamber 12 through the pipe 14a.

The substrate 1 is disposed on the support pedestal 16 in the film formation chamber 12. The film formation chamber 12 is heated to a predetermined temperature by the heater 13, and the internal space of the film formation chamber 12 is depressurized to a predetermined pressure by the vacuum pump 18.

The gas 2a introduced into the film formation chamber 12 is sprayed onto the surface of the substrate 1 from the discharge port 15. In the meantime, the pressure in the internal space of the film formation chamber 12 is adjusted by the vacuum pump 18.

The gas 2a is brought into contact with the surface of the substrate 1, and the compound represented by Formula (1) which is the gas 2a is allowed to undergo a chemical reaction, and thus a thin film having a Si-R¹ group is formed on the surface of the substrate 1.

### Method of Manufacturing Semiconductor Substrate

The method of manufacturing a semiconductor substrate according to an embodiment of the present invention includes at least manufacturing a substrate with a thin film and forming a resist film, and further includes, as necessary, forming a resist pattern, processing the thin film, processing the substrate, and the like.

### Manufacturing of Substrate With Thin Film

This step is a step of manufacturing a substrate with a thin film having a Si-R¹ group by using the method of manufacturing a substrate with a thin film according to an embodiment of the present invention.

### Formation of Resist Film

This step is a step of forming a resist film above the thin film having a Si-R¹ group.

The resist film can be formed by a well-known method, that is, by applying a resist material above the thin film having a Si-R¹ group and baking the thin film with the resist material applied.

A thickness of the resist film is not particularly limited, and is, for example, from 50 to 10000 nm, preferably from 100 to 2000 nm, more preferably from 200 to 1000 nm, and even more preferably from 30 to 200 nm.

Examples of the resist material used to form the resist film include a photoresist material and an electron beam resist material.

The photoresist material is not particularly limited as long as it is sensitive to the light used for the exposure during the formation of a resist pattern, and is, for example, a positive photoresist material.

Examples of the positive photoresist material include (i) to (iv) below.
(i) A chemically amplified photoresist material containing a binder having a group that is to be decomposed by an acid to increase the alkali dissolution rate of a resist film, and a photoacid generator
(ii) A chemically amplified photoresist material containing a low-molecular-weight compound that is to be decomposed by an acid to increase the alkali dissolution rate of a resist film, an alkali-soluble binder, and a photoacid generator
(iii) A chemically amplified photoresist material containing a binder having a group that is to be decomposed by an acid to increase the alkali dissolution rate of a resist film, a low-molecular-weight compound that is to be decomposed by an acid to increase the alkali dissolution rate of a resist film, and a photoacid generator
(iv) A DNQ (diazonaphthoquinone)-novolac type non-chemically amplified photoresist material utilizing the difference in alkali dissolution rates between the exposed areas and the unexposed areas

Examples of commercially available products of the positive photoresist include PAR710 (available from Sumitomo Chemical Co., Ltd.), TDUR-P3435LP (available from Tokyo Ohka Kogyo Co., Ltd.), THMR-iP1800 (available from Tokyo Ohka Kogyo Co., Ltd.), and SEPR430 (available from Shin-Etsu Chemical Co., Ltd.).

The photoresist material may also be a negative photoresist material.

Examples of the negative photoresist material include (v) to (viii) below.
(v) A chemically amplified photoresist material containing a binder having a group that is to be decomposed by an acid to reduce the solvent dissolution rate of a resist film, and a photoacid generator
(vi) A chemically amplified photoresist material containing a binder that is to be desorbed by an acid to subsequently react and polymerize, to reduce the alkali dissolution/solvent dissolution rate of a resist film, and a photoacid generator
(vii) A non-chemically amplified photoresist material containing a binder that is to be desorbed by an acid to subsequently react and polymerize, to reduce the alkali dissolution/solvent dissolution rate of a resist film
(viii) A non-chemically amplified photoresist material containing a metal compound that is to be desorbed by light to subsequently react and polymerize, to reduce the alkali dissolution/solvent dissolution rate of a resist film

Examples of the electron beam resist include (ix) to (x) below.
(ix) An electron beam resist material containing a resin having a Si-Si bond in a main chain and an aromatic ring at a terminal, and an acid generator that generates an acid when irradiated with an electron beam
(x) An electron beam resist material containing a poly(p-hydroxystyrene) in which a hydroxyl group is substituted with an organic group containing N-carboxyamine, and an acid generator that generates an acid when irradiated with an electron beam

In the case of the latter electron beam resist material, the acid generated by the acid generator as a result of electron beam irradiation reacts with N-carboxyaminoxy groups in polymer side chains, whereupon the polymer side chains break down into hydroxyl groups, and the polymer becomes alkali-soluble and dissolves in an alkaline developer, forming a resist pattern.

Examples of the acid generator that generates an acid as a result of electron beam irradiation include halogenated organic compounds such as 1,1-bis[p-chlorophenyl]-2,2,2-trichloroethane, 1,1-bis[p-methoxyphenyl]-2,2,2-trichloroethane, 1,1-bis[p-chlorophenyl]-2,2-dichloroethane, and 2-chloro-6-(trichloromethyl)pyridine; onium salts such as a triphenyl sulfonium salt and a diphenyl iodonium salt; and sulfonic acid esters such as nitrobenzyl tosylate and dinitrobenzyl tosylate.

### Formation of Resist Pattern

This is step is a step of forming a resist pattern by exposing the resist film to light and developing the exposed resist film.

The exposure is performed using i-ray, KrF excimer laser, ArF excimer laser, extreme ultraviolet (EUV), electron beam (EB), or the like through, for example, a mask (reticle) for forming a predetermined pattern.

The development uses, for example, an alkaline developer.

The development is performed, for example, at a development temperature from 5 to 50°C for a development time from 10 to 300 seconds.

Examples of the alkaline developer include aqueous alkaline solutions, for example, aqueous solutions of alkali metal hydroxides such as potassium hydroxide and sodium hydroxide; aqueous solutions of quaternary ammonium hydroxides such as tetramethylammonium hydroxide, tetraethylammonium hydroxide, and choline; and aqueous solutions of amines such as ethanolamine, propylamine, and ethylenediamine. Further, a surfactant or the like may be added to these developers. It is also possible to use a method in which development is carried out with an organic solvent such as butyl acetate instead of the alkaline developer to develop an area of a photoresist film where the alkali dissolution rate has not been increased.

### Processing of Thin Film

This step is a step of processing the thin film by using a resist pattern as a mask to form a patterned thin film.

In this step, for example, the thin film is etched by using the resist pattern as a mask (protective film). The etching is performed by dry etching, for example. The thin film is patterned by etching, and the surface of the substrate is exposed through the patterned thin film.

Examples of a gas used for dry etching include tetrafluoromethane (CF₄), perfluorocyclobutane (C₄F₈), perfluoropropane (C₃F₈), trifluoromethane, carbon monoxide, argon, oxygen, nitrogen, sulfur hexafluoride, difluoromethane, nitrogen trifluoride, chlorine trifluoride, chlorine, trichloroborane, and dichloroborane.

The gas used for dry etching is preferably a halogen-based gas from the viewpoints of rapidly removing the thin film having a Si-R¹ group and suppressing a decrease in the thickness of the resist film during etching. The halogen-based gas is preferably a fluorine-based gas. Examples of the fluorine-based gas include tetrafluoromethane (CF₄), perfluorocyclobutane (C₄F₈), perfluoropropane (C₃F₈), trifluoromethane, and difluoromethane (CH₂F₂).

### Processing of Substrate

This step is a step of processing the substrate using the resist pattern and the patterned thin film as a mask.

In this step, for example, the substrate is etched using the resist pattern and the patterned thin film as a mask (protective film). The etching is performed by dry etching, for example. The substrate is processed by etching.

The aspect of processing the substrate is not particularly limited, and examples thereof include forming a groove and forming a through hole.

A gas used for the dry etching may be appropriately determined depending on the surface of the substrate in contact with the thin film.

For example, when the substrate has an organic film and the thin film is in contact with the organic film, the gas used for the etching is preferably oxygen gas.

For example, when the substrate is a silicon wafer and the thin film is in contact with the surface of the silicon wafer, the gas used for the etching is preferably a fluorine-based gas.

### Substrate With Thin Film

The substrate with a thin film according to an embodiment of the present invention has at least the thin film and the substrate.

The thin film has a Si-R¹ group of a compound represented by Formula (1).

The thin film is formed, for example, by bringing the compound represented by Formula (1) into contact with the surface of the substrate and further chemically reacting the compound represented by Formula (1). And the thin film has the Si-R¹ group of the compound represented by Formula (1).

The substrate has the thin film disposed on the surface thereof.

The substrate with a thin film is placed, for example, outside the film formation chamber.

The substrate with a thin film is formed, for example, by bringing the compound represented by Formula (1) into contact with the surface of the substrate and further chemically reacting the compound represented by Formula (1).

Details and examples of the thin film and the substrate include the details and examples described in the method of manufacturing a substrate with a thin film according to an embodiment of the present invention.

The substrate with a thin film can be suitably manufactured by the method of manufacturing a substrate with a thin film according to an embodiment of the present invention.

### Semiconductor Substrate

The semiconductor substrate according to an embodiment of the present invention has at least the substrate with a thin film according to an embodiment of the present invention and a resist film.

The resist film is disposed above the thin film.

Details and examples of the resist film include the details and examples described in the method of manufacturing a semiconductor substrate according to an embodiment of the present invention.

The semiconductor substrate can be suitably manufactured by the method of manufacturing a semiconductor substrate according to an embodiment of the present invention.

### Compound

The compound according to an embodiment of the present invention is a compound represented by Formula (1) described above.

The compound according to an embodiment of the present invention is used in the method of manufacturing a substrate with a thin film or the method of manufacturing a semiconductor substrate. In addition, the compound according to an embodiment of the present invention is used in manufacturing of the substrate with a thin film or manufacturing of the semiconductor substrate.

### Examples

Hereinafter, the present invention will be described more specifically with reference to Examples, but the present invention is not limited to the following Examples.

### Example 1

### Production of Substrate With Thin Film

The following compound was used as a raw material for thin film formation.

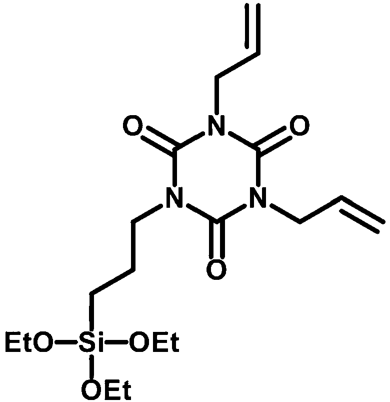

In the formula, "Et" represents an ethyl group.

The manufacturing device illustrated in FIG. 3 was used to manufacture the substrate with a thin film.

The raw material for thin film formation was placed in the raw material container 11.

A silicon wafer (substrate 1) which had been surface-treated with UV-ozone was placed on the support pedestal 16 in the film formation chamber 12.

The pressure in the film formation chamber 12 was adjusted to 20 mbar (2000 Pa), and the film formation chamber 12 was heated to 140°C using the heater 13.

The temperature of the raw material container 11 was adjusted to 140°C using the heater 13, and the pressure in the raw material container 11 was reduced to 20 mbar (2000 Pa), turning the raw material for thin film formation in the raw material container 11 into the gas 2a.

The raw material for thin film formation in the raw material container 11 already turned into the gas 2a was introduced into the film formation chamber 12 through the pipe 14a, and the raw material for thin film formation, i.e., the gas 2a, was brought into contact with the surface of the silicon wafer (substrate 1). This operation was carried out for 1 hour, forming a thin film having a diallyl isocyanurate propylsilyl group at the silicon wafer (substrate 1).

The silicon wafer (substrate 1) having the thin film was retrieved from the film formation chamber 12.

The thickness of the resulting thin film was measured using an ellipsometric film thickness measuring device ASET-F5 film thickness measuring device (available from KLA Corporation, the same applies hereinafter). The measurement result was 2.0 nm.

In addition, a water contact angle was measured using a fully automatic contact angle meter DM-701 (Kyowa Interface Science Co., Ltd.). The water contact angle of a silicon wafer which had been surface-treated with UV-ozone was 20°or less, whereas the water contact angle of the thin film formed on the silicon wafer was 71°. This increase in contact means that a thin film having a diallyl isocyanurate propylsilyl group was formed and the hydrophobicity was increased.

### Solvent Resistance Test

A mixed solvent of propylene glycol monomethyl ether/propylene glycol monomethylether acetate (7/3 (vol/vol)) was applied onto the thin film of a silicon wafer with a thin film obtained by the same method as described above, and spin-dried at 1500 rpm/30 seconds.

The thickness of the thin film after spin drying was measured using an ellipsometric film thickness measuring device, and the thin film was evaluated for whether the film thickness had decreased after the application of the mixed solvent. Based on the film thickness before the application of the mixed solvent, a film thickness decrease of less than 5% after application was evaluated as "good", and a film thickness decrease of 5% or greater after application was evaluated as "poor".

The results obtained are presented in Table 1.

**[Table 1]**

| | Solvent Resistance |
|---|---|
| Example 1 | Good |

From these results, it was confirmed that a thin film having solvent resistance was formed.

### Formation of Resist Pattern by EUV Exposure: Positive Alkaline Development

### Example 1

The thin film of a silicon wafer with a thin film obtained by the same method as described above was spin-coated with an EUV resist solution (methacrylate-polyhydroxystyrene resin-based resist), and heating was performed at 110°C for 1 minute, and thus an EUV resist film (C layer) was formed. Then, exposure was performed using an EUV exposure device (NXE 3400) available from ASML under the conditions of NA = 0.33, σ = 0.63/0.84, and Quadropole.

After the exposure, post-exposure bake (PEB, 105°C for 1 minute) was performed, and the resulting product was cooled to room temperature on a cooling plate. Then, development was carried out using a 2.38% TMAH developer for 30 seconds, and rinsing was performed, resulting in a resist pattern.

### Comparative Example 1

As Comparative Example 1, an EUV resist was formed in the manner described above on an untreated silicon wafer, and exposure and development were performed in the same manner.

Then, each of the resulting patterns was evaluated for whether a 28-nm-pitch 12-nm line pattern can be formed by observing cross-sections of the patterns to confirm the pattern shape.

During the observation of the pattern shape, a state in which the shape was found to be between "footing" and "undercut" and no significant residue was found in the space portion was evaluated as "good", and an unfavorable state in which the resist pattern collapsed was evaluated as "collapse". The results obtained are presented in Table 2.

**Table 2**

| | Pattern Shape |
|---|---|
| Example 1 | Good |
| Comparative Example 1 | Collapsed |

From the above, it was confirmed that a thin film that gives good resolution of EUV resist was formed.

### Industrial Applicability

According to the present invention, a novel thin film can be formed on a substrate, and thus the present invention is useful for manufacturing a substrate having a novel thin film and manufacturing a semiconductor substrate having a novel thin film.

### Reference Signs List

1 Substrate
1a Silicon Wafer
1b Organic Underlayer Film
2 Thin Film
2a Gas
11 Raw Material Container
12 Film Formation Chamber
13 Heater
14a, 14b Pipe
15 Discharge Port
16 Support Pedestal
17 Trap
18 Vacuum Pump

## Claims

1. A substrate with a thin film, comprising
the thin film comprising a Si-R¹ group of a compound represented by Formula (1), and
the substrate comprising the thin film comprising the Si-R¹ group, the thin film being disposed on a surface of the substrate,
Si(R¹)(R²)ₙ(R³)₃₋ₙ ··· Formula(1)
where in Formula (1), R¹ represents a monovalent organic group that bonds to Si; R² represents a monovalent organic group that bonds to Si; R³ represents an alkoxy group, an acyloxy group, or a halogen atom that bonds to Si; n represents an integer from 0 to 2; when n is 2, R² may be the same or different; when n is 0 or 1, R³ may be the same or different; and when n is 1, R¹ and R² may bond together to form a ring structure.

2. The substrate with a thin film according to claim 1, wherein the substrate with a thin film is formed by bringing the compound represented by Formula (1) into contact with the surface of the substrate and further chemically reacting the compound.

3. The substrate with a thin film according to claim 1 or 2, wherein the monovalent organic group in R¹ is a monovalent organic group having from 1 to 20 carbons and an oxygen atom.

4. The substrate with a thin film according to any one of claims 1 to 3, wherein in Formula (1), R¹ represents a monovalent group represented by Formula (2), and R² represents a monovalent group represented by Formula (2), or an alkyl group, an aryl group, an aralkyl group, a halogenated alkyl group, a halogenated aryl group, a halogenated aralkyl group, an alkenyl group, an organic group having an epoxy group, an organic group having an acryloyl group, an organic group having a methacryloyl group, an organic group having a mercapto group, an organic group having an amino group, an organic group having a cyano group, or a combination of two or more types of the foregoing, 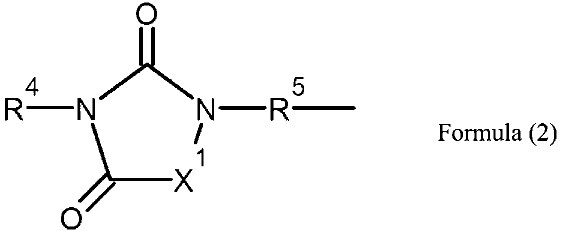
where in Formula (2), R⁴ represents a hydrogen atom, an alkyl group having from 1 to 10 carbons, an alkenyl group, an epoxy group, a sulfonyl group, or a monovalent organic group containing two or more types of the foregoing; R⁵ represents an alkylene group having from 1 to 10 carbons, a hydroxyalkylene group, a sulfide bond, an ether bond, an ester bond, or a combination of two or more types of the foregoing; and X¹ represents a divalent group represented by Formula (3), a divalent group represented by Formula (4), or a divalent group represented by Formula (5), 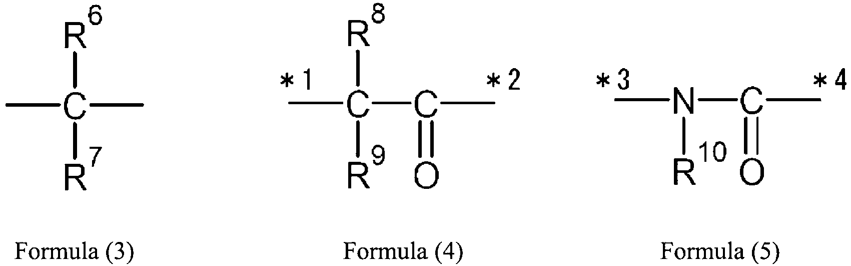
where, in Formula (3), Formula (4), and Formula (5), R⁶ to R¹⁰ each independently represent a hydrogen atom, an alkyl group having from 1 to 10 carbons, an alkenyl group, an epoxy group, a sulfonyl group, or a monovalent organic group containing two or more types of the foregoing; *1 and *3 are bonded to a carbon atom of a carbonyl group in Formula (2); and *2 and *4 are bonded to a nitrogen atom in Formula (2).

5. A semiconductor substrate comprising
the substrate with a thin film described in any one of claims 1 to 4, and
a resist film disposed above the thin film.

6. A method of manufacturing a substrate with a thin film, the method comprising
bringing a gaseous compound represented by Formula (1) into contact with a surface of a substrate, and further chemically reacting the compound to form a thin film comprising a Si-R¹ group of the compound on the surface of the substrate,
Si(R¹)(R²)ₙ(R³)₃₋ₙ ··· Formula(1)
where in Formula (1), R¹ represents a monovalent organic group that bonds to Si; R² represents a monovalent organic group that bonds to Si; R³ represents an alkoxy group, an acyloxy group, or a halogen atom that bonds to Si; n represents an integer from 0 to 2; when n is 2, R² may be the same or different; when n is 0 or 1, R³ may be the same or different; and when n is 1, R¹ and R² may bond together to form a ring structure.

7. The method of manufacturing a substrate with a thin film according to claim 6, wherein
the formation of the thin film on the surface of the substrate is performed in a film formation chamber, and
the method further comprises retrieving, from the film formation chamber, the substrate including the thin film having the Si-R¹ group, the thin film being formed on the surface of the substrate.

8. The method of manufacturing a substrate with a thin film according to claim 6 or 7, wherein the monovalent organic group in R¹ is a monovalent organic group having from 1 to 20 carbons and an oxygen atom.

9. The method of manufacturing a substrate with a thin film according to any one of claims 6 to 8, wherein in Formula (1), R¹ represents a monovalent group represented by Formula (2), and R² represents a monovalent group represented by Formula (2), or an alkyl group, an aryl group, an aralkyl group, a halogenated alkyl group, a halogenated aryl group, a halogenated aralkyl group, an alkenyl group, an organic group having an epoxy group, an organic group having an acryloyl group, an organic group having a methacryloyl group, an organic group having a mercapto group, an organic group having an amino group, an organic group having a cyano group, or a combination of two or more types of the foregoing, 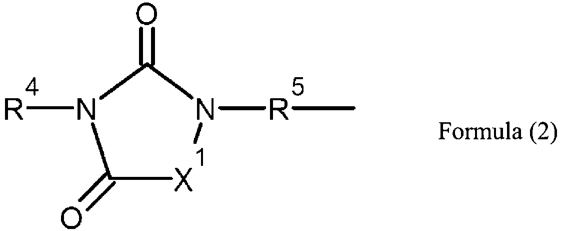
where in Formula (2), R⁴ represents a hydrogen atom, an alkyl group having from 1 to 10 carbons, an alkenyl group, an epoxy group, a sulfonyl group, or a monovalent organic group containing two or more types of the foregoing; R⁵ represents an alkylene group having from 1 to 10 carbons, a hydroxyalkylene group, a sulfide bond, an ether bond, an ester bond, or a combination of two or more types of the foregoing; and X¹ represents a divalent group represented by Formula (3), a divalent group represented by Formula (4), or a divalent group represented by Formula (5), 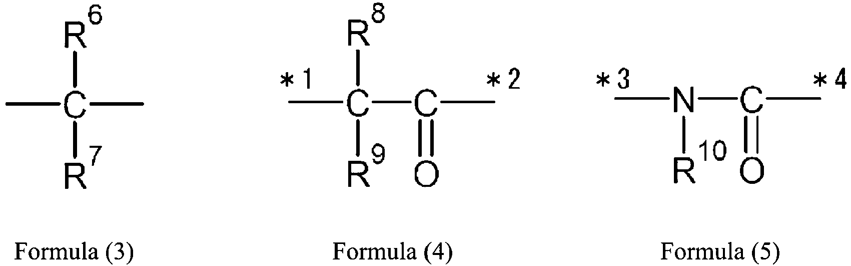
where in Formula (3), Formula (4), and Formula (5), R⁶ to R¹⁰ each independently represent a hydrogen atom, an alkyl group having from 1 to 10 carbons, an alkenyl group, an epoxy group, a sulfonyl group, or a monovalent organic group containing two or more types of the foregoing; *1 and *3 are bonded to a carbon atom of a carbonyl group in Formula (2); and *2 and *4 are bonded to a nitrogen atom in Formula (2).

10. The method of manufacturing a substrate with a thin film according to any one of claims 6 to 9, the method comprising gasifying the compound represented by Formula (1).

11. A method of manufacturing a semiconductor substrate, the method comprising:
manufacturing a substrate with a thin film by using the method of manufacturing a substrate with a thin film described in any one of claims 6 to 10; and
forming a resist film above the thin film.

12. Use of a compound represented by Formula (1) as defined in claim 1 in any one of:
manufacturing of the substrate with a thin film described in any one of claims 1 to 4;
manufacturing of the semiconductor substrate described in claim 5;
the method of manufacturing a substrate with a thin film described in any one of claims 6 to 10; and
the method of manufacturing a semiconductor substrate described in claim 11.
